(19) Europäisches Patentamt
European Patent Office
Office européen des brevets

(11) EP 1 947 706 A1

(12) EUROPEAN PATENT APPLICATION
published in accordance with Art. 158(3) EPC

(43) Date of publication:
23.07.2008 Bulletin 2008/30

(21) Application number: 06810345.6

(22) Date of filing: 20.09.2006

(51) Int Cl.:
*H01L 51/30* (2006.01) *H01L 29/786* (2006.01)
*H01L 51/05* (2006.01)

(86) International application number:
PCT/JP2006/318649

(87) International publication number:
WO 2007/034841 (29.03.2007 Gazette 2007/13)

(84) Designated Contracting States:
DE

(30) Priority: 21.09.2005 JP 2005273725

(71) Applicant: Mitsubishi Chemical Corporation
Minato-ku
Tokyo 108-0014 (JP)

(72) Inventors:
- OHBA, Yoshihiro
Yonezawa-shi, Yamagata, 992-8510 (JP)
- SATO, Kazuaki
Yonezawa-shi, Yamagata, 992-8510 (JP)
- SAKAI, Yoshimasa
Aoba-ku, Yokohama-shi, Kanagawa, 227-8502 (JP)
- ARAMAKI, Shinji
Aoba-ku, Yokohama-shi, Kanagawa, 227-8502 (JP)

(74) Representative: HOFFMANN EITLE
Patent- und Rechtsanwälte
Arabellastrasse 4
81925 München (DE)

# (54) ORGANIC SEMICONDUCTOR MATERIAL AND ORGANIC FIELD EFFECT TRANSISTOR

(57) To provide an organic semiconductor material which can be subject to a coating process, and has high regularity, high crystallinity, and high stability, a compound having 6 to 20 five-membered and/or six-membered aromatic rings bonded to each other, and having a partial structure represented by the formula (1) below; having a mobility of $1.0 \times 10^{-3}$ $cm^2/Vs$ or more, and having an ionization potential in the solid state in the range of 4.8 eV to 5.6 eV is used.

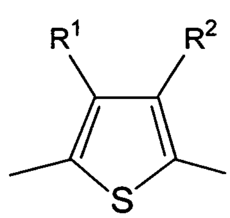

In the formula, $R^1$ and $R^2$ independently represent a hydrogen atom or a monovalent organic group, provided that at least one of $R^1$ and $R^2$ is an optionally substituted aromatic group.



Printed by Jouve, 75001 PARIS (FR)

## Description

Technical Field

The present invention relates to organic semiconductor materials with oligothiophene skeletons, and organic field-effect transistors formed thereof.

Background Art

Thin film transistors (hereinafter referred to as "TFTs") are widely used as switch elements in the electronics industry, especially for a variety of applications such as active matrix liquid crystal display devices and smart cards. Most thin film transistors (TFTs) are field-effect transistors (hereinafter referred to as "FETs").

At present, most TFT devices are fabricated with amorphous silicon as a semiconductor material. Manufacturing of amorphous silicon TFTs, however, requires high-cost processes, such as plasma enhanced chemical vapor deposition, and such processes must be carried out under vacuum at too high a temperature (approximately 360˚C) to use flexible plastic substrates.

Organic semiconductor materials have attracted much attention as semiconductor materials for TFTs. Examples of the organic semiconductor materials are described in Patent Document 1. Organic semiconductor material (small molecules, short-chain oligomers and polymers) are expected to provide low cost TFTs alternative to amorphous silicon as they can be processed into films through simple processes. Especially, devices with large areas can be made from solvent-soluble organic semiconductor materials by inexpensive processes such as spin coating, dip coating, and microcontact printing. Furthermore, organic semiconductor materials can be deposited at low temperatures, can be applied to a wider range of substrate materials including plastics, and therefore are expected to be used for achieving flexible electronic devices.

Until now, several types of short chain and oligomeric organic semiconductor materials have been synthesized (for example, α-sezithiophene:α-6T) and have demonstrated mobilities of 0.1 to 0.6 $cm^2/Vs$ close to that of amorphous silicon. However, these relatively high mobilities have been achieved only by vacuum deposition, since most of these organic semiconductor materials are hardly soluble in organic solvents.

To enhance the solubility in organic solvents, attempts are made to introduce alkyl groups into the above-mentioned oligomeric organic semiconductor materials. For example, Patent Document 2 and Nonpatent Document 1 report α-alkylsubstituted oligothiophenes. However, even such alkylsubstituted oligothiophenes do not exhibit sufficient solubility in organic solvents. Therefore, it is actually difficult to apply and process the oligothiophenes into films.

From the viewpoint of the enhancement of the solubility, several types of soluble polymeric semiconductor materials having mobilities of 0.001 to 0.01 $cm^2/Vs$ (for example, polyalkylthiophenes) are reported. However, such polymeric semiconductor materials are polymers, which can not readily be purified. Therefore, it takes much time and labor to obtain them at a high purity. The polymer film needs to show high crystallinity for high mobility. Therefore, special care is necessary for film formation and it is difficult to stably obtain satisfactory properties. Furthermore, due to their sensitivity to oxidation, these materials typically have low on-off ratios, they must be applied in an atmosphere of inert gas, and they must be sufficiently treated with base to reduce unintentional dopants introduced during polymerization to show semiconducting property.

Recently, to increase the on-off ratios of the polyalkylthiophenes, semiconductor materials whose molecular structures are designed to increase the ionization potential have come out (for example, Patent Document 3), but they are polymeric materials, which leads to wide variances in semiconductor properties and insufficient impurity removal.

[Nonpatent Document 1] Journal of Materials Chemistry, 2000, pp. 571-588[Patent Document 1] US Patent No. 5,347,144
[Patent Document 2] Japanese Unexamined Patent Publication No. 4-133351
[Patent Document 3] Japanese Unexamined Patent Publication No. 2003-268083

Disclosure of Invention

Problems to be solved by the Invention

Against the background above, there is a need for organic semiconductor materials, which can be subject to coating processes and maintain high regularity, and high crystallinity, and high stability.

The present invention has been made in consideration of the problems above. That is, objects of the present invention are to provide an organic semiconductor material which can be subject to a coating process, has high regularity, high crystallinity, and high stability; and to provide an organic field-effect transistor which is made therefrom and has excellent electrical properties such as mobility and excellent stability such as oxidation resistance.

Means for solving the Problem

As a result of extensive study in consideration of the problems of past material development, the inventors have discovered promising oligothiophenes that are low molecular weight oligomers capable of being highly purified and have enhanced solubility by introducing an aromatic substituent as a structure to increase ionization potential. Introduction of an aromatic substituent, which is bulky and tends to have a non-planar structure, into an oligothiophene has so far been believed to cause disturbance of the planarity of the molecule and to impair semiconductor properties. The inventors, however, have discovered the following fact and accomplished the present invention: low molecular weight oligothiophene semiconductor materials, which can be subject to coating processes and maintain high regularity, high crystallinity, and high stability, can be obtained by adjusting the position at which the substituent is introduced.

That is, the gist of the present invention consists in an organic semiconductor material having 6 to 20 five-membered and/or six-membered aromatic rings bonded to each other, and having a partial structure represented by the formula (1):

[Chemical Formula 1]

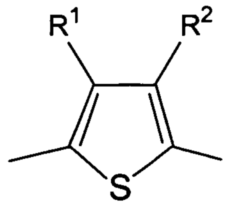

Formula (1)

wherein $R^1$ and $R^2$ independently represent a hydrogen atom or a monovalent organic group, provided that at least one of $R^1$ and $R^2$ is an optionally substituted aromatic group; and having a mobility of 1.0 X $10^{-3}$ $cm^2/Vs$ or more, and an ionization potential in the solid state in the range of 4.8 eV to 5.6 eV (claim 1).

The organic semiconductor material preferably has a solubility of 0.1 % by weight or more at 30°C in at least any one solvent of toluene, xylene, ethylbenzene, mesitylene, cyclopentanone, cyclohexanone, methyl chloride, carbon tetrachloride, chlorobenzene, dichlorobenzene, trichlorobenzene, nitrobenzene, methyl ethyl ketone, benzoic acid esters, anisole, phenetole, butyl phenyl ether, methoxytoluene, and benzyl ethyl ether (claim 2).

For the organic semiconductor material, the ratio of the molecular weight of the aromatic moiety (or moieties) of $R^1$ and $R^2$ in the general formula (1) to the molecular weight of the moiety of the 6 to 20 five-membered and/or six-membered aromatic rings bonded to each other is preferably 5% or more (claim 3).

The materials preferably have a partial structure represented by the formula (2):

[Chemical Formula 2]

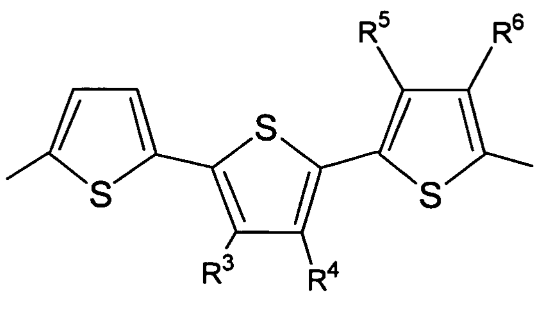

Formula (2)

wherein $R^3$ to $R^6$ independently represent a hydrogen atom or a monovalent organic group, provided that at least one of $R^3$ to $R^6$ is an optionally substituted aromatic group (claim 4).

Preferably, the organic semiconductor material is an oligothiophene (claim 5).

Another point of the present invention consists in an organic field-effect transistor comprising at least a substrate;

an insulator on the substrate; a gate electrode and a semiconductor separated by the insulator; and a source electrode and a drain electrode in contact with the semiconductor, the semiconductor comprising at least the organic semiconductor material according to any one of claims 1 to 5 (claim 6).

The semiconductor is preferably made by a solution coating process (claim 7).

Effects of the Invention

The organic semiconductor material of the present invention can be subject to a solution coating process, and has high regularity, high crystallinity, and high stability. The organic field-effect transistor of the present invention, which contains the material in the semiconductor, also has excellent electrical properties such as high mobility, high oxidation resistance, and excellent stability of electrical characteristics.

Brief Description of the Drawings

[Fig. 1] Fig. 1 is a cross-sectional view that illustrates a structure of an organic FET of the present invention.
[Fig. 2] Fig. 2 is a cross-sectional view that illustrates another structure of the organic FET of the present invention.
[Fig. 3] Fig. 3 is a cross-sectional view that illustrates a further structure of the organic FET of the present invention.
[Fig. 4] Fig. 4 shows the ionization potential of the organic semiconductor material produced in Examples.
[Fig. 5] Fig. 5 shows X-diffraction peaks of the organic semiconductor material produced in Example.
[Fig. 6] Fig. 6 shows semiconductor characteristics of the organic FET produced in Example.

Description of Reference Numerals

1 supporting substrate (substrate)
2 gate electrode
3 insulating layer (insulator)
4 semiconductor layer (charge-transporting layer, semiconductor)
5 source electrode
6 drain electrode

Best Mode for Carrying Out the Invention

The present invention will now be described in detail, but should not be limited to the description below. Various modifications can be made within the scope of the gist of the invention.

[I. Organic Semiconductor Material]

[I-1. Structure of Organic Semiconductor Material]

The organic semiconductor material of the present invention is a compound having 6 to 20 five-membered and/or six-membered aromatic rings bonded to each other, and having a partial structure represented by the formula (1):
[Chemical Formula 3]

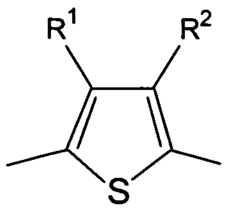

Formula (1)

In the organic semiconductor material of the present invention, the number of the five-membered and/or six-membered aromatic rings bonded to each other is generally 6 or more and preferably 8 or more, and generally 20 or less and preferably 15 or less. In an organic semiconductor material containing less aromatic rings than this range, π-conjugated electrons cannot be delocalized, and semiconductor characteristics of the material may be impaired. A material containing more aromatic rings than this range cannot be readily synthesized.

In the formula (1), $R^1$ and $R^2$ independently represent a hydrogen atom or a monovalent organic group, provided that at least one of $R^1$ and $R^2$ is an optionally substituted aromatic group. The phrase "aromatic group" as used herein refers to aromatic hydrocarbon group and aromatic heterocyclic group.

One of the $R^1$ and $R^2$ must be an aromatic group, and the aromatic group includes, for example, optionally substituted aromatic hydrocarbon groups such as phenyl group, naphthyl group, and tolyl group; optionally substituted aromatic heterocyclic groups such as pyridyl group, pyrazolyl group, quinolyl group, imidazolyl group, and benzthiazolyl group. Among them, preferred are aromatic hydrocarbon groups, and especially preferred are phenyl group and naphthyl group. The aromatic group may have any substituent that does not significantly impair the advantages of the present invention. The substituents include, for example, halogen atoms such as fluorine atom and chlorine atom; and alkyl groups, alkene groups, alkynyl groups, alkoxy groups, acyl groups, alkylthio groups, cyano groups, and hydroxy groups having a carbon number of 12 or less. A plurality of these substituents may be substituted. Among them, preferred is alkyl group. The number of the substituents may be either one or more. Furthermore, these substituents may be incorporated alone or in any combination thereof at any proportion.

Preferably, at least one of the $R^1$ and $R^2$ is an aromatic group, and the other is not an aromatic group. When both are aromatic groups, these aromatic groups are almost perpendicular due to steric hindrance. This will lead to reduction of π conjugation characteristics over the entire molecule.

The number of the partial structures of the formula (1) contained in the organic semiconductor material of the present invention may be at least one without limitation, but preferably two or more, and more preferably four or more. In an organic semiconductor material containing less partial structures of the formula (1) than this range, π conjugation cannot be delocalized, and semiconductor characteristics tend to be impaired.

In the organic semiconductor material of the present invention, the ratio of the molecular weight of the aromatic moiety of $R^1$ and $R^2$ in the general formula (1) to the molecular weight of the moiety of the 6 to 20 five-membered and/or six-membered aromatic rings bonded to each other is preferably 5% or more, more preferably 8% or more, even more preferably 10% or more. The moiety of the 6 to 20 five-membered and/or six-membered aromatic rings bonded to each other here means a moiety, exclusive of substituents other than hydrogen, where aromatic rings are connected with each other. The aromatic moiety of $R^1$ and $R^2$ in the general formula (1) means an aromatic ring moiety, exclusive of substituents other than hydrogen, in $R^1$ and $R^2$

Preferred examples of partial structures other than the partial structure of the formula (1) contained in the organic semiconductor material of the present invention include, but not limited to, structures represented by the formulae (I) to (VII).

[Chemical Formula 4]

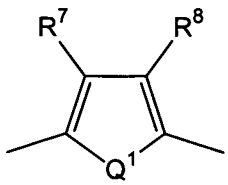

Formula (I)

[Chemical Formula 5]

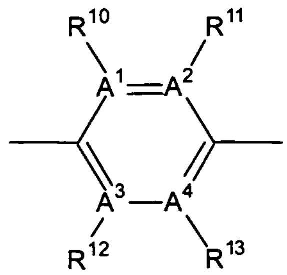

Formula (II)

[Chemical Formula 6]

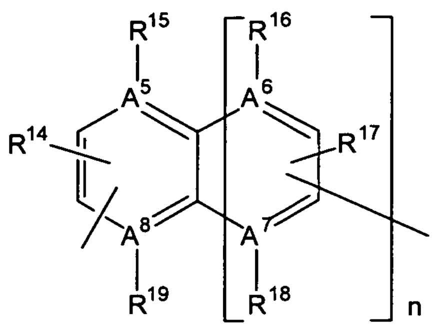

Formula (III)

wherein n represents an integer from zero to six.

[Chemical Formula 7]

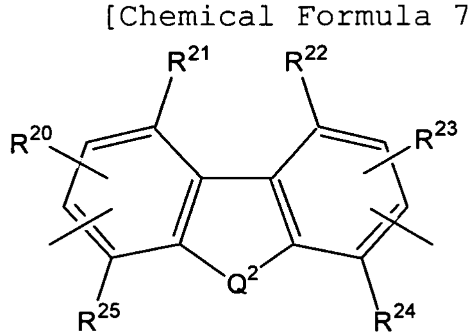

Formula (IV)

[Chemical Formula 8]

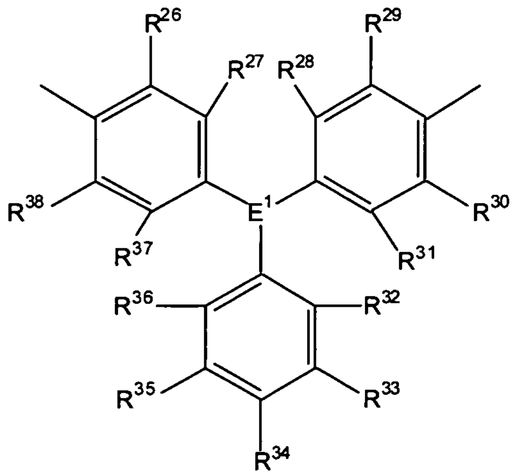

Formula (V)

[Chemical Formula 9]

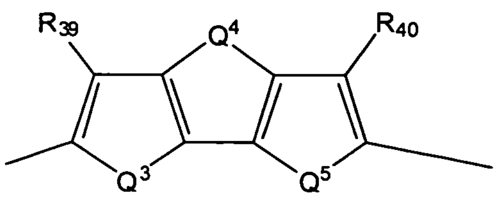

Formula (VI)

[Chemical Formula 10]

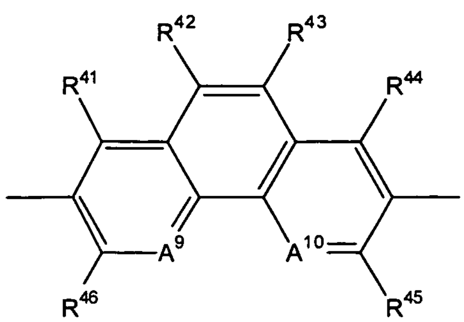

Formula (VII)

In the formulae (I) to (VII), each symbol is defined as follows.

$R^7$, $R^8$, and $R^{10}$ to $R^{46}$ independently represent
H,
F,
$CH_3$-,
$CH_3(CH_2)_n$- (n represents an integer from 1 to 23),

$CH_3(CH_2)_n(CF_2)_m$- (n and m independently represent an integer from 1 to 23),
$CF_3$-,
$CF_3(CF_2)_n$- (n represents an integer from 1 to 23),
$CF_3(CH_2)_n(CF_2)_m$- (n and m independently represent an integer from 1 to 23),
nitro group,
amino group,
cyano group,
carboxyl group,
sulfonate group,
hydroxy group, or
alkoxy group.

$A^1$ to $A^{10}$ independently represent a carbon atom or a nitrogen atom.

$Q^1$ to $Q^5$ independently represent $-CR^{47}R^{48}-$, $-NR^{49}-$, -N-, -S-, $-SiR^{50}R^{51}-$, or -Se- ($R^{47}$ to $R^{51}$ independently represent a hydrogen atom, a linear, branched, or cyclic alkyl group having a carbon number of 1 to 23, or a fluorine-substituted alkyl group wherein the alkyl group is replaced with one or more fluorine atoms).

$E^1$ represents a nitrogen atom or

[Chemical Formula 11].

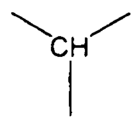

Among the structures represented by the formulae (I) to (VII), preferred are the structures represented by the formula (I), formula (III), and the formula (VI), and particularly preferred is the structure represented by the formula (I). Furthermore, among the structures represented by the formula (I), particularly preferred is the structure wherein $Q^1$ is a sulfur atom, and $R^7$ and $R^8$ are hydrogen atoms.

The organic semiconductor material of the present invention is preferably an oligothiophene. In the case that the organic semiconductor material of the present invention is an oligothiophene, the intermolecular distance can be sufficiently close to promote crystallization due to mutual interaction of sulfur atoms on thiophene rings, resulting in an advantage of enhanced semiconductor characteristics.

In particular, the organic semiconductor material of the present invention preferably has a partial structure represented by the formula (2):

[Chemical Formula 12]

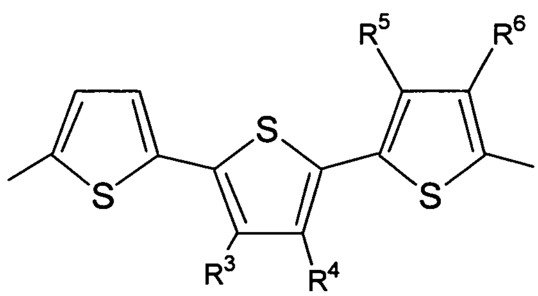

Formula (2)

wherein $R^3$ to $R^6$ independently represent a hydrogen atom or a monovalent organic group, provided that at least one of the $R^3$ to $R^6$ is an optionally substituted aromatic group.

Preferred examples of $R^3$ to $R^6$ include those same as $R^1$ and $R^2$ of the formula (1).

The number of the partial structures of the formula (2) contained in the organic semiconductor material of the present invention may be at least one without limitation, but preferably two or more. In an organic semiconductor material containing less partial structures of the formula (2) than this range, $\pi$ conjugation cannot be delocalized, and semiconductor characteristics tend to be impaired.

Preferred examples of partial structures other than the partial structure of the formula (2) contained in the organic semiconductor material of the present invention include the partial structures of formulae (I) to (VII) as mentioned above. Among them, particularly preferred are the structures represented by the formula (I), and more particularly preferred is a structure wherein $Q^1$ represents a sulfur atom, and $R^7$ and $R^8$ are hydrogen atoms.

From the viewpoint of maintaining the planarity of the thiophene oligomeric molecule, the organic semiconductor material of the present invention particularly preferably has a partial structure represented by the formula (3):

[Chemical Formula 13]

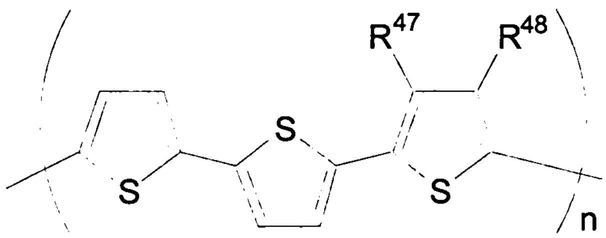

Formula (3)

wherein $R^{47}$ and $R^{48}$ independently represent a hydrogen atom or a monovalent organic group, provided that at least one of the $R^{47}$ to $R^{48}$ is an optionally substituted aromatic group. Preferred examples of the $R^{47}$ and $R^{48}$ are same as those of $R^1$ and $R^2$ of the formula (1).

In the formula (3), n represents an integer from 2 to 5. Aromatic groups exceeding this range cause the planarity within the n-conjugated system moiety to significantly decrease and lower semiconductor characteristics.

For an organic semiconductor material having a high carrier mobility, preferably adjacent molecules in a solid state overlap finely, because interaction between the π-electron orbitals is important for transfer of carriers, that is, electrons or positive holes between molecules. It is well known that in organic semiconductors, n electrons play an important role in charge transport. However, it is not yet known that n electrons are conjugated in a macroscopic scale to exhibit semiconductor characteristics.

In particular, conjugation of π electrons in a molecular crystal is limited within one molecule, and charge transport is achieved by charge transfer among molecules. In such a case, as overlapping of π orbitals conjugated within one molecule is more significant, the efficiency of the charge transport increases. As a result, the mobility in the molecular crystal is generally direction-dependent. Therefore, highly crystalline materials have generally higher mobility than that of amorphous materials.

In order to increase the overlapping of π orbitals between molecules, a high planarity of the n-conjugated systems in the molecules is desired. For existing thiophene oligomers, the introduction of alkyl groups that do not impair the planarity of the n-conjugated system has primarily been studied so far. In the present invention, it has been found that even when a substituent is a bulky aryl group, controlling the position at which the substituent is introduced can provide higher solubilities in organic solvents than those of the alkyl groups without greatly impairing the planarity. In addition, the introduction of a bulky aromatic group as a substituent can lead to partial displacement from the planarity to abate the n-conjugation characteristics. As a result, ionization potential can be successfully increased to inhibit oxidation of the molecule, so that the on-off ratio can be increased.

The organic semiconductor material of the present invention, which has 6 to 20 five-membered and/or six-membered aromatic rings bonded to each other as described above, has any group at its ends (hereinafter referred to as "terminal group") that do not adversely affect the semiconductor characteristics. Examples of the preferred terminal groups include halogen atoms such as fluorine atom and chlorine atom; and alkyl groups, alkene groups, alkynyl groups, alkoxy groups, acyl groups, alkylthio groups, cyano groups, and hydroxy groups having a carbon number of 16 or less. Especially preferred are a fluorine atom and alkyl groups having a carbon number of 16 or less.

Preferred specific examples of the organic semiconductor material of the present invention include, but not limited to, compounds represented by chemical formulae below wherein "Hex" represents hexyl group, and "Ar" represents aromatic group.

[Chemical Formula 14]

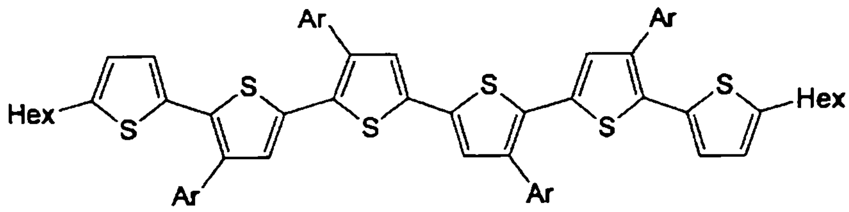

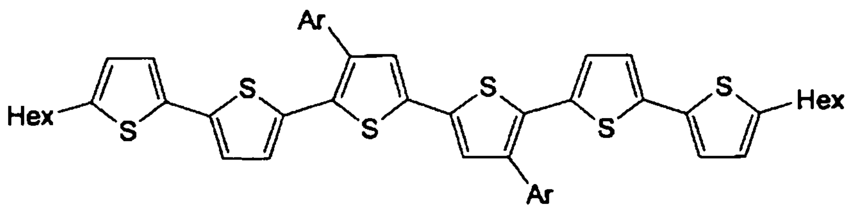

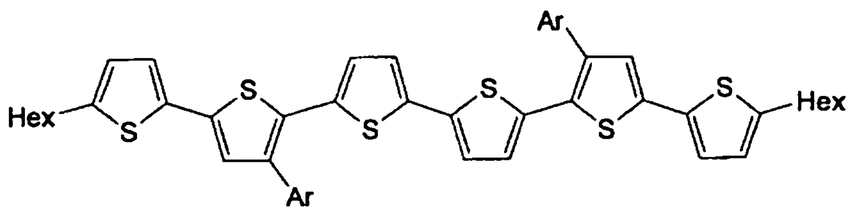

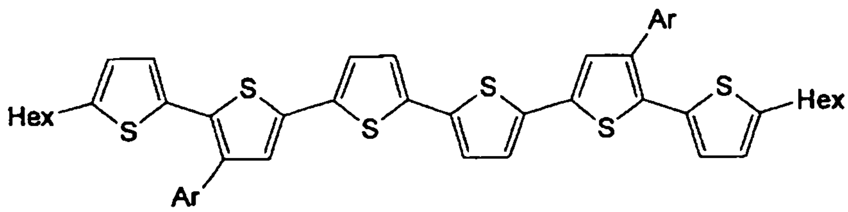

[Chemical Formula 15]

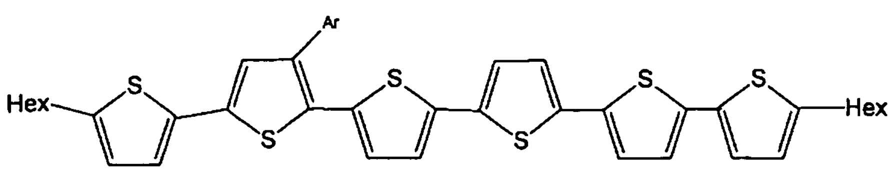

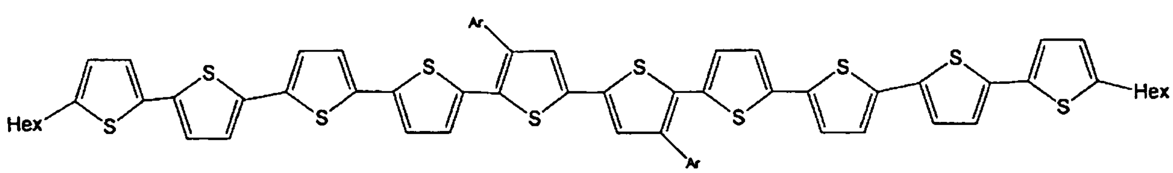

[Chemical Formula 16]

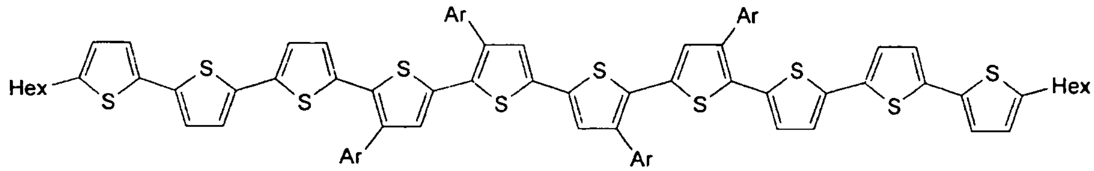

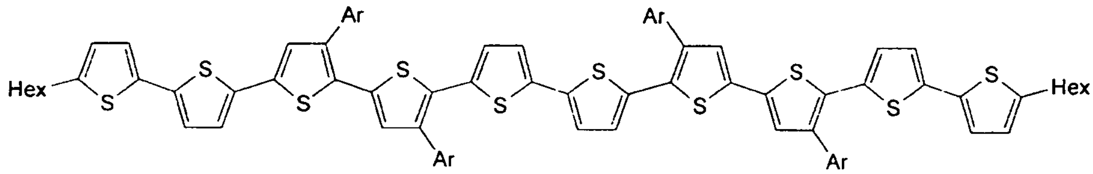

[Chemical Formula 17]

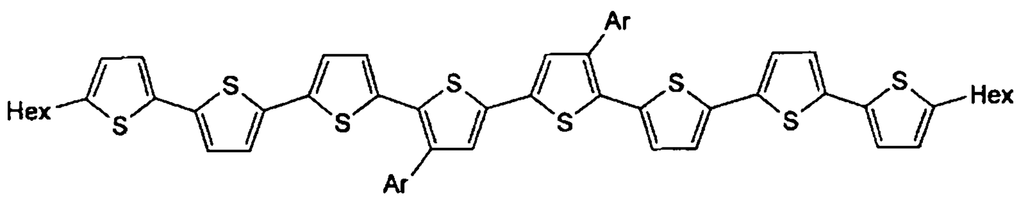

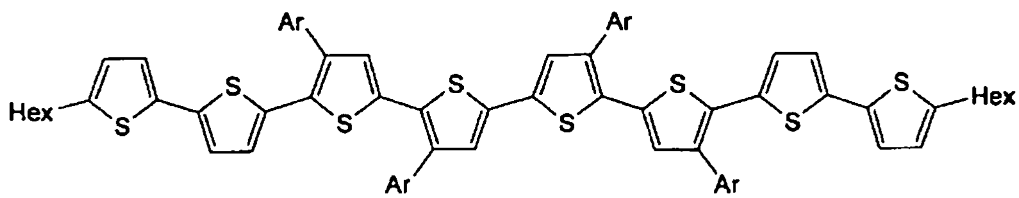

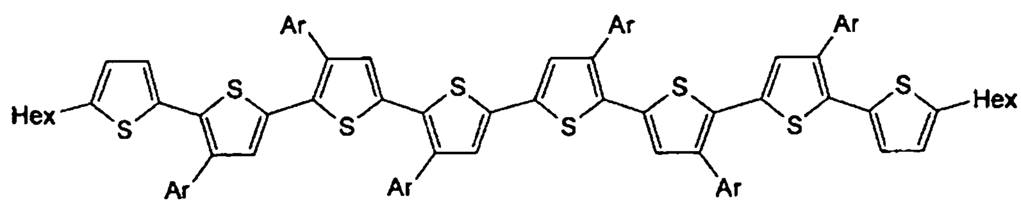

[Chemical Formula 18]

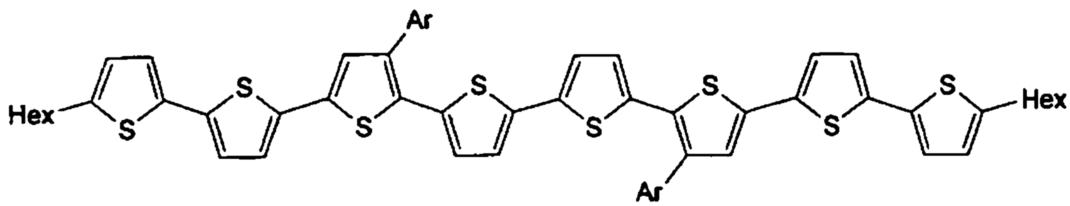

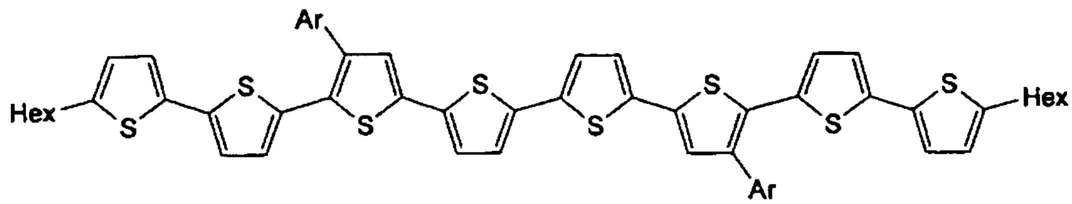

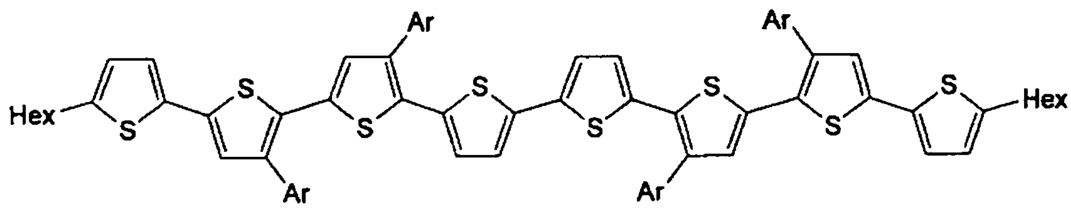

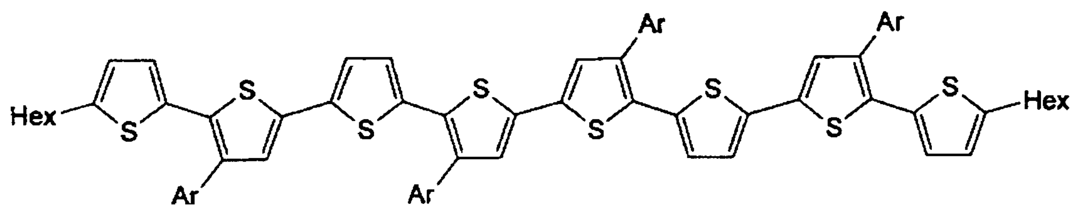

[Chemical Formula 19]

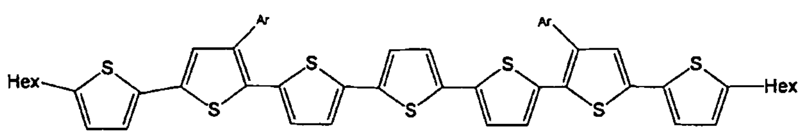

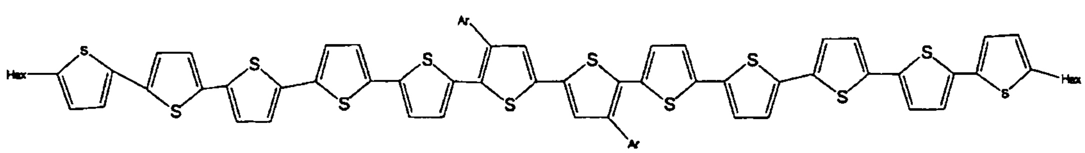

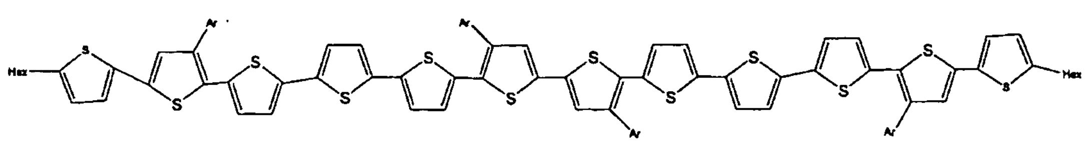

[I-2. Synthesis of Organic Semiconductor Material]

The organic semiconductor material of the present invention may be synthesized by any of various known methods, without limitation. A representative example of the methods of synthesizing the material is described below, but not limited to this method.

In this method, the organic semiconductor material of the present invention can be relatively readily synthesized

through the following first to third steps. The first and second steps are common regardless of the structure of the material. In each reaction scheme below, "Ar" represents aromatic group, "Phe" represents phenyl group or phenylene group, and "Ac" represents acetyl group.

• First Step:

In the first step, the chloro group at position 2 of 2,5-dichlorothiophene is eliminated, while an aromatic group is simultaneously introduced into position 3 to yield 3-aryl-5-chlorothiophene by a Friedel-Craft reaction using aluminium chloride as described in Sone et al., Bulletin of the Chemical Society of Japan, 1970, pp. 1411 (Reaction Scheme 1).
[Chemical Formula 20]

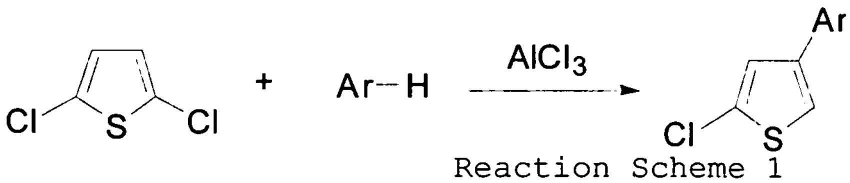


Reaction Scheme 1

In the above reaction, the aromatic compound (the compound represented by Ar-H in the above reaction scheme) and aluminium chloride are each preferably used in an equivalent amount to 2,5-dichlorothiophene. However, excess amounts of aromatic compound and aluminium chloride may be present in the reaction system. Any solvent that can dissolve 2,5-dichlorothiophene and the aromatic compound is used for the reaction, and preferred is tetrahydrofuran (THF). Although the reaction time is not particularly limited, it is usually one hour or more and preferably four hours or more and usually 100 hours or less and preferably 24 hours or less. Although the reaction temperature is not particularly limited, it is usually ambient temperature or more and preferably 40˚C or higher and usually 200˚C or lower and preferably 100˚C or lower. The reaction may also be conducted under any pressure, and usually under normal pressures.

• Second step:

In the second step, 3-aryl-5-chlorothiophene synthesized in the first step is iodinated at position 2, and reacted with metal magnesium to prepare a Grignard's compound. This Grignard's reagent is cross-coupled with a halogenated (such as brominated and chlorinated) aromatic compound in the presence of a palladium catalyst (e.g., Pd(dppf)$Cl_2$) to give its aromatic-substituted thiophene derivative without elimination of the chloro group. In the following example, 3-aryl-5-chlorothiophene is reacted with 2-bromobithiophene as a halogenated aromatic compound (Reaction Scheme 2).
[Chemical Formula 21]

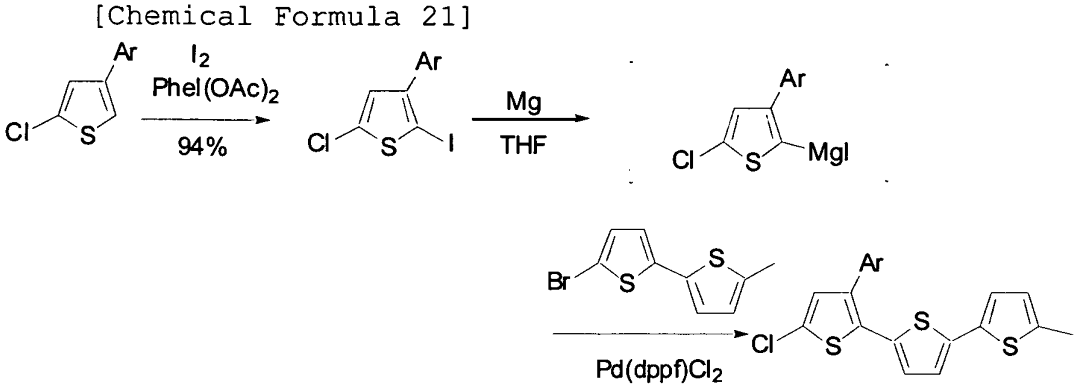


Reaction Scheme 2

In the above reaction, iodine, metal magnesium, and 2-bromobithiophene are each preferably used in an equivalent amount to 3-aryl-5-chlorothiophene, and 0.01 equivalent of palladium catalyst is preferably used. However, excess amounts of 2-bromobithiophene and the palladium catalyst may be present in the reaction system. Any solvent

that can dissolve 3-aryl-5-chlorothiophene and 2-bromobithiophene is used for the reaction, and especially preferred are THF and diethyl ether. Although the reaction time is not particularly limited, it is usually one hour or more and especially four hours or more, and usually 100 hours or less and especially 24 hours or less. Although the reaction temperature is not particularly limited, it is usually ambient temperature or more and preferably 40˚C or hgiher, and usually 200˚C or lower and preferably 100˚C or lower. The reaction may also be conducted under any pressure, and usually under normal pressures.

• Third Step:

In the third step, the chloro group of the aromatic-substituted thiophene derivative with a terminal chloro group obtained in the second step is monometalated (monolithiumated) with n-butyllithium, and the lithiumated aromatic-substituted thiophene is oxidatively coupled with various oxidizing agents, particularly copper chloride by the method described in Garnier et al., Journal of the American Chemical Society, 1993, Vol. 115, p. 8716, to give an organic semiconductor material of the present invention as a hexamer or higher of aromatic-substituted thiophene oligomer.

Any solvent that can dissolve aromatic-substituted thiophene derivatives with a terminal chloro group is used for the reaction, and especially preferred are THF and diethyl ether. Although the reaction time is not particularly limited, it is usually one hour or more and especially four hours or more, and usually 100 hours or less and especially 24 hours or less for monometalation (monolithiumation), and usually one hour or more and especially four hours or more, and usually 100 hours or less and especially 24 hours or less for the oxidative coupling reaction. Although the reaction temperature is not particularly limited, it is usually -40˚C or higher and preferably -30˚C or higher, and usually 0˚C or lower and preferably -5˚C or lower for the monometalation (monolithiumation), and usually 25˚C or higher and preferably 40˚C for the oxidative coupling reaction. The reaction may also be conducted under any pressure, and usually under normal pressures or higher.

[I-3. Physical properties of the Organic Semiconductor Material]

The organic semiconductor material of the present invention has a mobility of $1.0 \times 10^{-3}$ $cm^2/Vs$ or more. This mobility is preferably $5.0 \times 10^{-3}$ $cm^2/Vs$ or more, and more preferably $1.0 \times 10^{-2}$ $cm^2/Vs$ or more. A lower mobility may cause low semiconducting performance and high driving voltage in the application to field-effect transistors. The upper limit of the mobility is not particularly defined, but usually 10 $cm^2/Vs$ or less. The mobility can be determined under an atmosphere at 25˚C by the method of measuring electrical current and voltage.

The structure of the organic semiconductor material of the present invention can be analyzed and identified by, for example, nuclear magnetic resonance (hereinafter abbreviated to "NMR") spectrometry, infrared (hereinafter abbreviated to "IR") spectrometry, elemental analysis, and mass spectroscopy (hereinafter abbreviated to "MS").

The organic semiconductor material of the present invention has a molecular weight in the range of usually 248 or more and preferably 330 or more, and usually 20,000 or less and preferably 10,000 or less. In an organic semiconductor material having a molecular weight below this range, n conjugation cannot be delocalized, and semiconductor characteristics tend to be impaired. In an organic semiconductor material having a molecular weight above this range, a n-conjugated structure cannot be formed. The molecular weight of the organic semiconductor material of the present invention can be determined by mass spectrometry such as, for example, Matrix Assisted Laser Desorption Ionization (hereinafter abbreviated to "MALDI-TOF-MS"). In particular, it can be measured by MALDI-TOF-MS according to, for example, the method described in Macromolecules, 2001, Vol. 34, No. 21, pp. 7570-7572.

Ionization potential (Ip) is used as a typical measure of stability of the organic semiconductor material. Representative thiophene materials including low-molecular $\alpha$-hexathiophene ($\alpha$-6T) and high-molecular regioregular poly(3-hexylthiophene-2,5-diyl) (P3HT) usually have an ionization potential (Ip) of about 4.7 eV, and are readily oxidized.

On the contrary, the organic semiconductor material of the present invention has a higher ionization potential because a selected aromatic group is partially introduced into the material. The ionization potential (Ip) of the organic semiconductor material of the present invention is usually 4.8 eV or more and preferably 4.9 eV or more, and usually 5.6 eV or less, preferably 5.5 eV or less, and more preferably 5.4 eV or less. At a lower ionization potential of the material, the organic semiconductor may be oxidized to enhance its conductivity and on-off ratio. At a higher ionization potential of the material, charge-injection from the electrode may be decreased.

The ionization potential is preferably determined by the method of measuring a sample in a solid state through photoelectron spectroscopy. Examples of the simple devices include a photoelectron spectrometer, model AC-1 (or its successor device) available from Riken Keiki Co., Ltd.

[1-4. Applications of the Organic Semiconductor Material]

The organic semiconductor material of the present invention, which can be subject to solution coating process

and shows high semiconductor characteristics, can be used as an electronic device that transports charges in a thin film. Such electronic devices include field-effect transistors, electroluminescence (hereinafter abbreviated to "EL") devices, solar cells, and photoconductors (photosensitive devices). The most preferred application of the material is field-effect transistors.

The carrier mobility required for application of the organic semiconductor material to organic electronic devices such as organic field-effect transistors can be determined by the intensity and switching speed of electrical current to be controlled, and the structure of the device. Use of the organic semiconductor material of the present invention can provide an organic device having a carrier mobility of usually $1\times10^{-3}$ $cm^2/Vs$ or more. The mobility of the conventional organic semiconductor material in a molecular crystal is usually about 1 $cm^2/Vs$ or less for condensed aromatic hydrocarbons such as pentacene in the form of molecular crystal. The thiophene oligomeric molecule may increase molecular interaction due to highly delocalized $\pi$ orbitals, and seems to have a mobility of about 10 $cm^2/Vs$, and even about 100 $cm^2/Vs$.

Another factor that ensures a high mobility of the organic electronic device is the purity of the semiconductor materials as semiconductor components. Even trace amounts of impurities that trap carriers may cause a significant reduction in the mobility. The energy level of accepting carriers of these impurities that readily serve as a trap resides within the energy gap of the semiconductor. Specifically, impurities readily serving as such a trap have a highest occupied molecular orbital (hereinafter abbreviated to "HOMO") level above that of the semiconductor in the case of carriers being positive holes, or have a lowest unoccupied molecular orbital (hereinafter abbreviated to "LUMO") level below that of semiconductor in the case of carriers being electrons.

At a high concentration, even impurities without the above energy level causes a defective crystalline structure in the semiconductor, resulting in a reduction in the mobility. Therefore, the concentration of impurities is desirably low, preferably 10% or less, and more preferably 1% or less. A method of producing a semiconductor layer using a highly soluble precursor (an organic semiconductor material of the present invention) as described below has an advantage of forming a semiconductor layer (semiconductor) made from a highly-purity organic semiconductor material.

Although the organic semiconductor material of the present invention usually utilizes positive holes as carriers, it can also utilize electrons as carriers by selecting substituents on the aromatic groups to show electron transport characteristics.

There is a preferred carrier energy level for the applications such as field-effect transistors that require smooth charge injection from the electrode. A significantly low HOMO level of the positive holes undesirably increases the barrier to charge injection. A significantly high HOMO level may cause the material to be readily oxidized in air and to be unstable. Consequently, the ionization potential in a solid state corresponding to the HOMO level is usually 5.6 eV or less, preferably 5.5 eV or less, and more preferably 5.4 eV or less, and usually 4.8 eV or more and preferably 4.9 eV or more.

Preferably, the organic semiconductor material of the present invention is present in a solid state at room temperature (for example, between about 20°C and about 30°C) because it can be easily applied to organic electronic devices. Depending on substituents in the formula (1) or the formula (2), compounds showing liquid crystallinity can be obtained, and can be used as an organic semiconductor regardless of the liquid crystalline state. In particular, the organic semiconductor material of the present invention has a principal axis structure with high planarity, so that it can produce smectic liquid crystal, which is favorable for carrier transport. In the case of use of the organic semiconductor material of the present invention in a solid state at room temperature, significant changes in properties of the organic electronic device at its service temperature range are not preferred. Therefore, the phase transition temperature of the material, such as melting point or freezing point, preferably does not lie in the range of 5°C to 40°C. Preferably, the organic semiconductor material of the present invention in a solid state at room temperature also has a melting point or glass transition temperature of usually 50°C or higher and especially 100°C or higher.

The organic semiconductor material of the present invention usually shows a high solubility in solvents that can slightly dissolve conventional organic semiconductor materials. Specifically, a solubility of the material in at least one of toluene, xylene, ethylbenzene, mesitylene, cyclopentanone, cyclohexanone, methyl chloride, carbon tetrachloride, chlorobenzene, dichlorobenzene, trichlorobenzene, nitrobenzene, methyl ethyl ketone, benzoic acid esters, anisole, phenetole, butyl phenyl ether, methoxytoluene, benzyl ethyl ether at 30°C is usually 0.1% by weight or more, preferably 0.3% by weight or more, and more preferably 0.5% by weight or more. On the other hand, the upper limit of the solubility is not defined, but usually 20% by weight or less. A material having a significantly low solubility cannot be subject to a coating process, resulting in unsuccessful film formation.

Preferably, when the organic semiconductor material of the present invention is dissolved in a certain organic solvent to yield a solution, the surface tension of the solution is usually in the range of 10 mN/m to 60 mN/m, the viscosity is usually in the range of 1 mPa·s to 50 mPa·s, and the boiling point is usually in the range of 50°C to 250°C. These criteria are important for application in the coating process. The surface tension is measured at a temperature of 25°C, a humidity of 60%, and a solution concentration of 0.3% by weight. The viscosity is measured at a temperature of 25°C, a humidity of 60%, and a solution concentration of 0.3% by weight. Similarly, the boiling point is measured with a solvent

having a solution concentration of 0.3% by weight under an atmospheric pressure.

[II. Organic Field-Effect Transistor]

The organic field-effect transistor composed of the organic semiconductor material of the present invention (hereinafter abbreviated to "field-effect transistor of the present invention" or "FET of the present invention") will now be described.

[II-1. Construction and Production of Organic Field-Effect Transistor]

An FET of the present invention includes a substrate; an insulator on the substrate; a gate electrode and a semiconductor separated by the insulator; and a source electrode and a drain electrode in contact with the semiconductor, the semiconductor comprising at least the organic semiconductor material of the present invention.

Figs. 1 to 3 are each a schematic cross-sectional view of an exemplary structure of the FET of the present invention. The basic structure of the FET of the present invention includes, for example, an insulating layer (insulator) 3; a gate electrode 2 and a semiconductor layer (charge-transporting layer, semiconductor) 4 separated by the insulating layer 3; and a source electrode 5 and a drain electrode 6 in contact with the semiconductor layer 4, on a supporting substrate (substrate) 1 as shown in Figs. 1 to 3. Each electrode (the gate electrode 2, the source electrode 5, and the drain electrode 6) is connected by a certain wire as necessary. However, the FET of the present invention should not be limited to the FETs with structures shown in Figs. 1 to 3. For example, each layer may be layered in any order other than the orders shown in Figs. 1 to 3, and any additional layer may be added to these layers shown in Figs. 1 to 3.

The supporting substrate 1 may be composed of any material that can support the FET of the present invention, and display elements and display panels formed on the FET. Examples of the substrates include inorganic substrates, such as glass substrates, and plastic substrates made from polymers. Among them, preferred materials are plastic substrates selected from the group consisting of polyesters, polycarbonates, polyimides, polyethersulfones, amorphous polyolefins, epoxy resins, polyamides, polybenzoxazole, polybenzothiazole, vinyl polymers, polyparabanic acid, polysilsesquioxane, and siloxanes. More preferred are polyesters such as polyethylene terephthalate and polyethylene naphthalate, and general-purpose resins such as polycarbonates due to their strength and cost. Also, preferred are crosslinked materials of condensed polymers such as polyimides, polyamides, polybenzoxazole, polybenzothiazole, polyparabanic acid, and polyvinylphenols that can be thermally insolubilized in view of heat resistance and solvent resistance. Especially preferred materials for the supporting substrate are, for example, polyesters, polycarbonates, polyimides, and polybenzoxazole, and the most preferred are polyesters such as polyethylene terephthalate and polyethylene naphthalate, and polyimides.

Materials for the insulating layer 3 include polymers such as polymethyl methacrylate, polystyrene, polyvinylphenols, polyimide, polycarbonates, polyesters, polyvinyl alcohol, polyvinyl acetate, polyurethanes, polysulfones, polybenzoxazoles, polysilsesquioxane, epoxy resins, and phenolic resins, and copolymers combined therewith; oxides such as silicon dioxide, aluminum oxide, and titanium oxide; nitride films, such as silicon nitride; and ferroelectric oxide films, such as $SrTiO_3$ and $BaTiO_3$; or polymer films containing dispersed particles of the above oxides, nitrides, and ferroelectric oxides. Among these materials, polymeric materials are compatible with the organic semiconductor material of the present invention used for the semiconductor layer 4 as described below. Preferably, the polymeric material for the insulating layer 3 has a glass transition temperature (Tg) of 80˚C or higher. A polymeric material having a Tg of lower than 80˚C may have high flowability that provides a film with a nonuniform thickness and an irregular surface and cannot maintain the shape of the insulating layer 3. The polymeric material is preferably can be dissolved in a solvent that does not dissolve the supporting substrate 1, and has solvent resistance such that the material cannot be eroded by the solvent during the formation of the semiconductor layer 4 by a coating process as described below.

The insulating layer 3 can be formed by any method depending on the material properties, for example, coating (such as spin coating and blade coating), vapor deposition, sputtering, printing such as screen printing and ink jet printing, and a method of forming an oxide film on a metal, such as an alumite film on aluminium. In particular, the insulating layer 3 composed of a polymeric material is preferably formed by a coating process or its analogous technology.

The coating process is an approach of forming a film by dissolving or dispersing a material in a suitable solvent to prepare a coating solution, applying the solution, and removing the solvent. Any kind of solvents that can suitably dissolve or disperse the material and does not adversely affect the material may be used without limitation for preparation of the coating solution. Although halogen compounds, ketone compounds, ester compounds, and aromatic compounds are usually used, alcohol solvents may also be used. These solvents may be used either alone or in any combination thereof at any proportion. Examples of the usable coating methods include casting including merely dropping and drying a coating solution; coating processes such as spin coating, dip coating, blade coating, wire-bar coating, and spray coating; printing processes such as ink jet printing, screen printing, offset printing, and relief printing; and soft lithography such as microcontact printing, and combination of these approaches.

The techniques analogous to the coating process include a Langmuir-Blodgett process including forming a monomolecular film on water surface and depositing the film on a substrate, and a process including disposing a material in the form of liquid crystal or melt between two substrates or filling the gap between these substrates by capillary action with the material.

The insulating layer 3 formed by the coating process and crosslinking reaction affects the leakage current to the gate electrode 2 and the low gate voltage drive of the FET. Therefore, the layer preferably has an electric conductivity at room temperature of $10^{-12}$ S/cm or less and more preferably $10^{-14}$ S/cm or less, and preferably has a relative dielectric constant of 2.0 or more and more preferably 2.5 or more. In order to obtain such an insulating layer 3, the upper limit of the thickness of the insulating layer 3 is usually 4 μm and preferably 2 μm or less. The lower limit of the thickness of the insulating layer 3 is usually 0.1 μm or more and preferably 0.2 μm or more. In general, an increased electrostatic capacity of the insulating layer 3 will advantageously allow the FET to be driven at a low gate voltage. To achieve this, the insulating layer 3 should be composed of a material with a high dielectric constant, or should have a smaller thickness, for example.

The semiconductor layer 4 contains an organic semiconductor material of the present invention. The organic semiconductor materials of the present invention may be used either alone or in any combination thereof at any proportion. In addition, one or more kinds of the organic semiconductor materials of the present invention may be used in combination with one or more kinds of other semiconductor materials. Furthermore, various additives may be used together as necessary.

The semiconductor layer 4 is usually formed by processing the organic semiconductor material of the present invention (and other semiconductor materials and additives as necessary) into a film on the supporting substrate 1 or the insulating layer 3. Although the film is formed by any approach without limitation, it is usually by an application process, that is, by a coating process or its analogous technology. The detailed coating process and exemplary technology analogous to the coating process are described above for the insulating layer 3. It should be noted that when the semiconductor layer 4 is formed on the insulating layer 3, a solvent that does not dissolve the insulating layer 3 should be selected for the coating solution. In combined use of a plurality of semiconductor materials, these materials may be mixed to form a single layer. Alternatively, these materials may be individually processed into individual films that are deposited into a laminated structure.

The thickness of the semiconductor layer 4 is not particularly limited. In an organic FET including the semiconductor layer 4 as thick as needed or more, the characteristics of the FET do not depend on the thickness of the semiconductor layer 4. However, the leakage current increases with the thickness of the semiconductor layer 4 in many cases. Therefore, the preferred thickness is usually 1 nm or more and preferably 10 nm or more, and usually 10 μm or less and preferably 500 nm or less.

The semiconductor layer 4 can have improved characteristics by post-processing. For example, the layer can be thermally processed to relax the strain in the film caused during the film formation, resulting in improved and stabilized characteristics. Exposure of the layer to oxidizing or reducing gases or liquids, such as oxygen and hydrogen can also induce changes in the characteristics through oxidation or reduction. This can be applied, for example, to adjusting the carrier density in the film.

Examples of materials for each electrode (the gate electrode 2, the source electrode 5, and the drain electrode 6) and wire include conductive materials such as metals e.g. as gold, aluminium, copper, chromium, nickel, cobalt, titanium, platinum, magnesium, calcium, barium, and sodium; conductive oxides e.g. as $InO_2$ $SnO_2$, and ITO; conductive polymers e.g. polyaniline, polypyrrole, polythiophene, polyacetylene, and polydiacetylene, and these materials doped with acids such as hydrochloric acid, sulfuric acid, and sulfonic acid, Lewis acids e.g. $PF_6$, $AsF_5$, and $FeCl_3$, halogen atoms such as iodine, and metal atoms such as sodium, and potassium; semiconductors e.g. silicon, germanium, and gallium arsenide, and these doped materials; and conductive composite materials containing dispersed carbonaceous materials, e.g. fullerene, carbon nanotubes, and graphite, and dispersed metal particles.

The method of forming each electrode (the gate electrode 2, the source electrode 5, and the drain electrode 6) and wire is not particularly limited, and well known methods such as vacuum deposition, sputtering, coating, printing, and sol-gel processes can be used. Examples of the usable patterning methods include photolithography by combination of patterning of a photoresist with etching with an etchant or reactive plasma; printing processes such as ink jet printing, screen printing, offset printing, and relief printing; and soft lithography such as microcontact printing, and combination of these approaches. The patterning can also be directly performed by irradiating a certain material with energy beams such as laser and electron beams to remove the certain material and change the conductivity of the material.

On the surface of the formed semiconductor layer 4, each of the formed electrodes (the gate electrode 2, the source electrode 5, and the drain electrode 6), and the wires, a protective film can be formed for minimizing atmospheric effects. Examples of the protective films include polymer film such as epoxy resins, acrylic resins, polyurethanes, polyimides, and polyvinyl alcohol, inorganic oxide films and nitride films such as silicon oxide, silicon nitride, and aluminium oxide. Examples of methods of forming the polymer film include a method of applying and drying a polymer solution and a method of applying or depositing a monomer and polymerizing it. In addition, crosslinking and formation of a multilayer

may also be available. For forming inorganic films, vacuum processes such as sputtering and deposition, and solution processes represented by a sol gel process can be also used.

[11-2. Applications of Organic Field-Effect Transistor]

The organic FET of the present invention can be used in any application depending on the kind of the FET. Typical examples of the applications of the FET of the present invention are described below, but not limited to these applications.

• Active Matrix:

For example, the FET of the present invention can be used as a switching element for an active matrix display element (a display). This provides a fast-response and high-contrast display by switching the electrical current between the source and drain electrodes with a voltage applied to the gate electrode, or switching on the circuit during only the time when a voltage is applied or a current is supplied to a display element and switching off the circuit during the other time.
Examples of the display devices to which the organic FET of the present invention can be applied include liquid crystal display devices, polymer-dispersed liquid crystal display devices, electrophoretic display devices, electroluminescent elements, and electrochromic display devices.
In particular, the organic FET of the present invention can be processed at low temperatures to fabricate such elements, and therefore substrates that cannot endure high-temperature processes can be used, such as plastic substrate, plastic films, and paper. The FET, which can also be processed to fabricate such elements by a coating or printing process, is suitable for applications to large-area display elements. The FET can also be subject to energy- and cost-saving processes, which is advantageous as an alternative to conventional active matrices.

• IC:

Integration of the organic FET of the present invention can provide digital devices and analog devices. Examples of such devices include logic circuits such as AND, OR, NAND, and NOT circuits, memory devices, oscillation devices, and amplifying devices. Combined use of these devices can provide IC cards and IC tags.

• Sensor:

In general, external stimuli such as gases, chemical substances, and temperatures cause significant changes in properties of organic semiconductor materials. Based on this phenomenon, the FET of the present invention may be applied to sensors. For example, quantitative measurement of changes in the properties of the FET of the present invention through contact with gas or liquid can allow qualitative or quantitative detection of chemical substances in the gas or liquid.

[Examples]

The present invention will now be described in detail by reference to the examples below, but not limited to these examples within the scope of the invention.

[I. Synthesis of Organic Semiconductor Material]

Oligothiophenes A to E (the organic semiconductor materials of the present invention) were synthesized according to the following syntheses 1 to 14. In the beginning of each synthesis, the outline of the reaction in each synthesis is illustrated by each reaction scheme. As used in each synthesis and each reaction scheme, "Phe" refers to phenyl group or phenylene group, "Et" to ethyl group, "Ac" to acetyl group, "Hex" to hexyl group, "NBS" to N-bromosuccinimide, and "DMF" to N,N-dimethylformamide.

[Synthesis 1]

·Synthesis of 2-Chloro-4-ethylphenylthiophene:

[Chemical Formula 22]

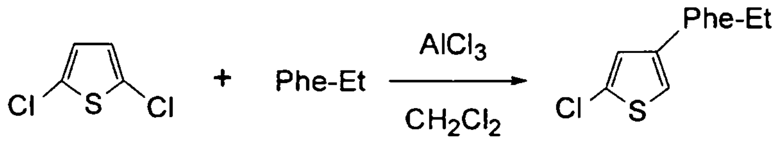


To a mixture of 30.6 g (0.20 M) of 2,5-dichlorothiophene, 100 ml (0.77 M) of ethylbenzene, and 100 ml of dichloromethane was added 26.7 g (0.20 M) of aluminum chloride, followed by refluxing for one hour. The reaction mixture was poured into 300 g of iced water, and the aqueous layer was separated from the organic layer. The organic layer was washed with 5% aqueous sodium hydrogencarbonate (100 ml), and dried over calcium chloride. After removal of excess ethylbenzene by distillation under reduced pressure, the residue was subject to silica gel column chromatography (solvent:n-hexane) to recover a target product, 24.3 g of 2-chloro-4-ethylphenylthiophene. The target product was obtained in a yield of 55% as white crystal with a melting point (hereinafter abbreviated to "mp.") of 97 to 98°C (literature data (hereinafter abbreviated to "lit.") 97 to 98°C).

[Synthesis 2]

·Synthesis of 5-Chloro-3-ethylphenyl-2-iodothiophene:

[Chemical Formula 23]

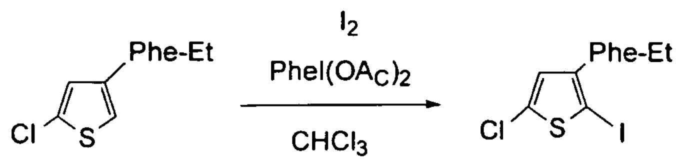


A mixture of 8.90 g (40 mM) of 2-chloro-4-ethylphenylthiophene prepared in Synthesis 1, 5.08 g (20 mM) of iodine, 7.09 g (22 mM) of iodobenzene diacetate, and 80 ml of chloroform was refluxed for one hour, washed sequentially with saturated aqueous sodium thiosulfate (100 ml) and water (100 ml), and dried over calcium chloride. After removal of the by-product iodobenzene by distillation under reduced pressure, the residue was purified by silica gel column chromatography (solvent:n-hexane) to recover a target product, 5-chloro-3-ethylphenyl-2-iodothiophene (13.1 g). The target product was obtained in a viscous yield of 94% as yellow oil.

[Synthesis 3]

• Synthesis of 5'-Chloro-3'-ethylphenyl-5"-hexyl-2,2':5,2"-terthiophene:

[Chemical Formula 24]

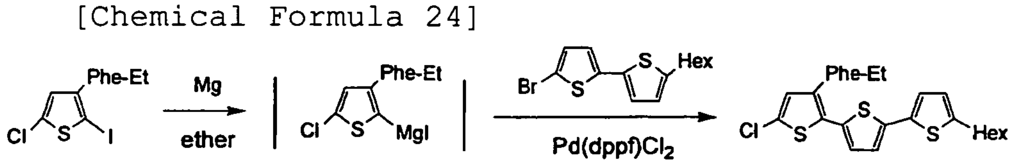


A Grignard's reagent prepared from 6.27 g (18 mM) of 5-chloro-3-ethylphenyl-2-iodothiophene prepared in Synthesis 2 and 0.48 g (19.8 mM) of magnesium in dry ether was added to 8.90g (40 mM) of 5-hexyl-5'-chloro-2,2'-bithiophene dissolved in dry toluene (25 ml), and refluxed for 4 hours in the presence of 0.29 g (0.36 mM) of palladium diphenylphosphinoferrocene dichloride as a catalyst. After addition of 5% hydrochloric acid (20 ml) with stirring, the

aqueous layer was separated from the organic layer. The organic layer was washed with 5% aqueous sodium hydrogencarbonate (10 ml), and dried over sodium sulfate. The resultant crude product was purified by silica gel column chromatography (solvent:n-hexane) to recover a target product, 5'-chloro-3'-ethylphenyl-5"-hexyl-2,2':5,2"-terthiophene (4.36 g). The target product was obtained in a yield of 77% as viscous yellow oil. The structure of the target product was identified by MS and $^1$H NMR. The results are shown below.

MS(EI): m/z 470 ($M^+$, 100%)

$^1$H NMR(500MHz, $CDCl_3$): δ 7.26 (d, J = 7.6Hz, 2H), 7.18 (d, J = 7.6Hz, 2H), 6.89 (s, 1H), 6.89 (d, J = 3.9Hz, 1H), 6.87 (d, J = 3.6Hz, 1H), 6.80 (d, J = 3.9Hz, 1H), 6.63 (d, J = 3.6Hz, 1H), 2.76 (t, J = 7.6Hz, 2H), 2.67 (q, J = 7.6Hz, 2H), 1.65 (m, 2H), 1.40-1.24 (m, 9H), 0.88 (t, J = 7.6Hz, 3H)

[Synthesis 4]

·Synthesis of Oligothiophene A (Hexamer):

[Chemical Formula 25]

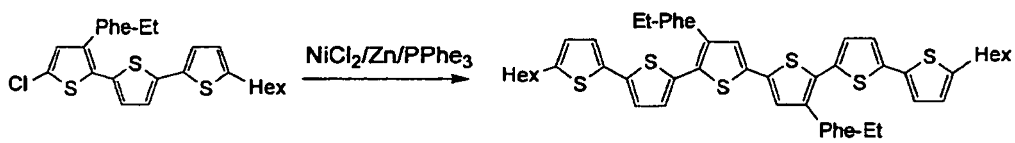


Under nitrogen stream, 0.78g (6 mM) of anhydrous nickel chloride, 6.30g (24 mM) of triphenylphosphine and 0.39g (6 mM) of zinc powder were added to dry DMF (30 ml), and stirred at 50˚C for one hour. Then, a solution of 2.36 g (5 mM) of 5'-chloro-3'-ethylphenyl-5"-hexyl-2,2':5,2"-terthiophene prepared in Synthesis 3 dissolved in dry DMF (3 ml) was added, and stirred at 50˚C for one hour. The reaction mixture was poured into 300 ml of water. The resultant reddish black precipitate was suction-filtered out, and washed with 200 ml of water. This precipitate was purified by silica gel column chromatography (solvent:n-hexane) to recover a target product, the oligothiophene A (hexamer) (1.8 g). The target product was obtained in a yield of 83% as red needle crystal with a mp. of 115 to 116˚C. The structure of the target product was identified by $^1$H NMR. The results are shown below.

$^1$H NMR (500MHz, $CDCl_3$): δ 7.26 (d, J = 7.6Hz, 4H), 7.18 (d, J = 7.6Hz, 4H), 6.89 (s, 2H), 6.89 (d, J = 3.9Hz, 2H), 6.87 (d, J = 3.6Hz, 2H), 6.80 (d, J = 3.9Hz,2H), 6.63 (d, J = 3.6Hz, 2H), 2.76 (t, J = 7.6Hz, 4H), 2.67(q, J = 7.6Hz, 4H), 1.65 (m, 4H), 1.40-1.24 (m, 18H), 0.88 (t, J = 7.6Hz, 6H)

[Synthesis 5]

·Synthesis of 5'-Hexyl-2,2':5,2"-terthiophene:

[Chemical Formula 26]

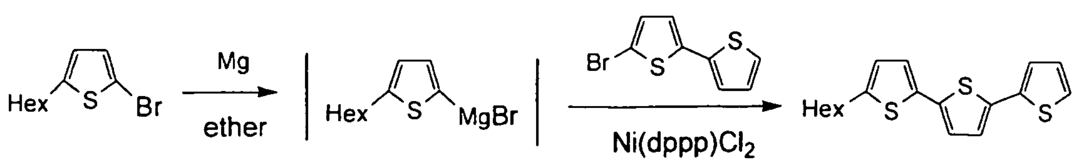


A Grignard's reagent prepared from 6.60 g (26.7 mM) of 2-hexyl-5-bromo-thiophene and 0.71 g (29.4 mM) of magnesium in dry ether was added to 4.36 g (17.8 mM) of 5-bromo-2,2'-bithiophene dissolved in dry ether (20 ml), and stirred at room temperature for 2 hours in the presence of 0.19 g (0.35 mM) of nickel diphenylphosphinopropane dichloride as a catalyst. After addition of 5% hydrochloric acid (30 ml) with thorough stirring, the aqueous layer was separated from the organic layer. The organic layer was washed with 5% aqueous sodium hydrogencarbonate (10 ml), and dried over sodium sulfate. The resultant crude product was purified by silica gel column chromatography (solvent:n-hexane) to recover a target product, 5'-hexyl-2,2':5,2"-terthiophene (4.6 g). The target product was obtained in a yield of 88% as

yellow needle crystal with a mp. of 63 to 63.5°C. The structure of the target product was identified by MS and $^1$H NMR. The results are shown below.

MS(EI): m/z 322($M^+$, 100%)

$^1$H NMR (500MHz, $CDCl_3$): δ 7.20 (dd, J = 5.1Hz and 1.5Hz, 1H), 7.15 (dd, J = 3.9Hz and 1.5Hz, 1H), 7.05 (d, J = 3.9Hz, 1H), 7.01 (dd, J = 5.1Hz and 3.9Hz, 1H), 6.99 (d, J = 3.6Hz, 1H), 6.98(d, J = 3.9Hz, 1H), 6.68 (d, J = 3.6Hz, 1H), 2.80 (t, J = 7.6Hz, 2H), 1.68 (m, 2H), 1.40-1.24 (m, 6H), 0.88 (t, J = 7.6Hz, 3H)

[Synthesis 6]

·Synthesis of 5'-Hexyl-5"-bromo-2,2':5,2"-terthiophene:

[Chemical Formula 27]

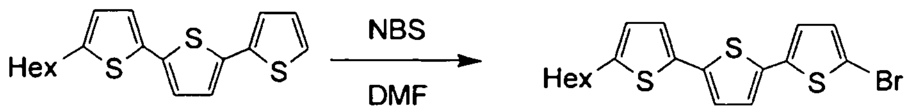


To a solution of 4.6 g (15 mM) of 5'-hexyl-2,2':5,2"-terthiophene prepared in Synthesis 5 dissolved in chloroform (15 ml) was added 2.67 g (15 mM) of N-bromosuccinimide, followed by stirring at room temperature for 3 hours. The reaction mixture was poured into 100 ml of water, and the aqueous layer was separated from the organic layer. The organic layer was washed with water, and dried over calcium chloride. The resultant crude product was purified by silica gel column chromatography (solvent:n-hexane) to recover a target product, 5'-hexyl-5"-bromo-2,2':5,2"-terthiophene (5.8 g). The target product was obtained in a yield of 93% as yellow flake crystal with a mp. of 84 to 85°C. The structure of the target product was identified by MS and $^1$H NMR. The results are shown below.

MS(EI): m/z 400 ($M^+$, 100%)

$^1$H NMR (500MHz, $CDCl_3$) : δ 6.98 (d, J = 3.9Hz, 1H), 6.97 (d, J = 3.9Hz, 1H), 6.97 (d, J = 3.9Hz, 1H), 6.96 (d, J = 3.6Hz, 1H), 6.87 (d, J = 3.9Hz, 1H), 6.66 (d,J = 3.6Hz, 1H), 2.79 (t, J = 7.6Hz, 2H), 1.67 (m, 2H), 1.40-1.28 (m, 6H), 0.89 (t, J = 7.6Hz, 3H)

[Synthesis 7]

·Synthesis of 5'-Hexyl-3'''-ethylphenyl-5'''-chloro-2,2':5,2":5",2'''-quaterthiophene:

[Chemical Formula 28]

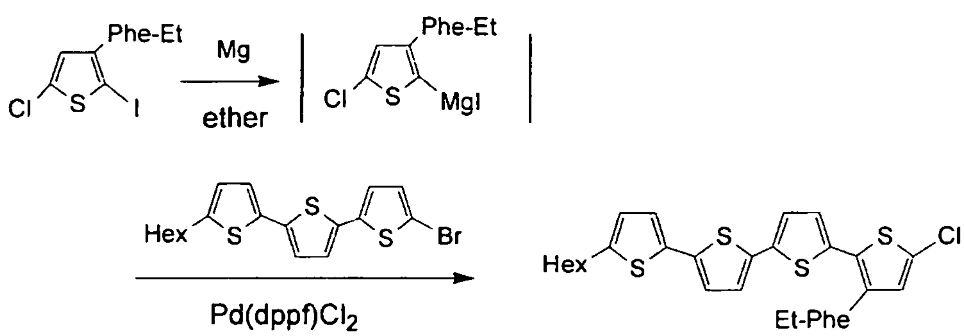


A Grignard's reagent prepared from 6.75 g (16.5 mM) of 5-chloro-3-ethylphenyl-2-iodothiophene prepared in Synthesis 2 and 0.42 g (18.1 mM) of magnesium in dry ether was added to a solution of 4.41 g (11.0 mM) of 5'-hexyl-5"-bromo-2,2':5,2"-terthiophene dissolved in dry toluene (20 ml), and refluxed for 4 hours in the presence of 0.29 g (0.36 mM) of palladium diphenylphosphinoferrocene dichloride as a catalyst. After addition of 5% hydrochloric acid (30 ml)

with thorough stirring, the aqueous layer was separated from the organic layer. The organic layer was washed with 5% aqueous sodium hydrogencarbonate (10 ml), and dried over sodium sulfate. The resultant crude product was purified by silica gel column chromatography (solvent:n-hexane) to recover a target product, 5'-hexyl-3'''-ethylphenyl-5'''-chloro-2,2':5,2":5",2'''-quaterthiophene (4.4 g). The target product was obtained in a yield of 87% as yellow needle crystal with a mp. of 85 to 86˚C. The structure of the target product was identified by MS and $^1$H NMR. The results are shown below.

MS (EI) : m/z 552 ($M^+$, 100%)

$^1$H NMR (500MHz, $CDCl_3$): δ 7.27 (d, J = 7.6Hz, 2H), 7.19 (d, J = 7.6Hz, 2H), 6.96-6.93 (m, 4H), 6.89 (s, 1H), 6.82(d, J = 3.9Hz, 1H), 6.67 (d, J = 3.6Hz, 1H), 2.78 (t, J = 7.6Hz, 2H), 2.68 (q, J = 7.6Hz, 2H), 1.66 (m, 2H), 1.40-1.28 (m, 6H), 1.26 (t, J=7.6Hz, 3H), 0.88 (t, J = 7.6Hz, 3H).

[Synthesis 8]

·Synthesis of Oligothiophene B (Octamer):

[Chemical Formula 29]

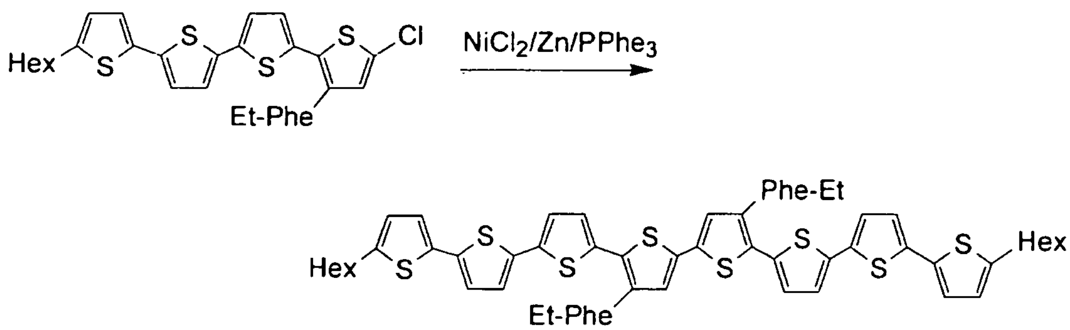


Under nitrogen stream, 0.65 g (5 mM) of anhydrous nickel chloride, 5.25 g (20 mM) of triphenylphosphine and 0.33g (5 mM) of zinc powder were added to 25 ml of dry DMF and heated at 50˚C for one hour with stirring. Then, a solution of 2.40 g (4.3 mM) of 5'-hexyl-3'''-ethylphenyl-5'''-chloro-2,2':5,2":5",2'''-quaterthiophene prepared in Synthesis 7 dissolved in dry DMF (3 ml) was added, and heated at 50˚C for additional one hour with stirring. The reaction mixture was poured into 300 ml of water, and the reddish black precipitate was suction-filtered out, and washed with 200 ml of water. This precipitate was Soxhlet-extracted with n-hexane to remove triphenylphosphine, and then Soxhlet-extracted with a hexanetoluene mixed solution to recover a target product, oligothiophene B (octamer) (2.0 g). The target product was obtained in a yield of 87% as red powder with a mp. of 159 to 161˚C. The structure of the target product was identified by $^1$H NMR. The results are shown below.

$^1$H NMR (500MHz, $CDCl_3$): δ7.35 (d, J = 7.6Hz, 4H), 7.23 (d, J = 7.6Hz, 4H), 7.14 (bs, 2H), 6.96-6.93 (m, 8H), 6.87 (s, 2H), 6.67 (d, J = 3.6Hz, 2H), 2.79 (t, J = 7.6Hz, 4H), 2.70 (q, J = 7.6Hz, 4H), 1.68 (m, 4H), 1.40-1.25 (m, 18H), 0.89 (t, J = 7.6Hz, 6H).

[Synthesis 9]

·Synthesis of 5',5"-Dibromo-2,2':5,2"-terthiophene:

[Chemical Formula 30]

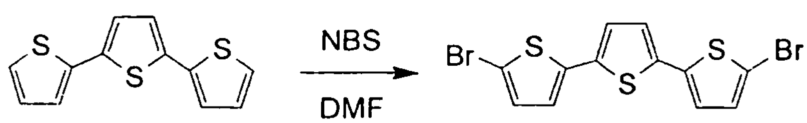

To a solution of 3.9 g (16 mM) of terthiophene dissolved in DMF (40 ml) was added 5.63 g (32 mM) of N-bromosuccinimide, followed by stirring at 40°C for 2 hours. The reaction mixture was poured into 400 ml of water. The resultant yellow precipitate was suction-filtered out, washed with 200 ml of hot water, and dried in a desiccator under reduced pressure to recover a target product, 5',5"-dibromo-2,2':5,2"-terthiophene (6.1 g). The target product was obtained in a yield of 96% as yellow flake crystal with a mp. of 156 to 158°C (lit. 160 to 161°C) .

[Synthesis 10]

·Synthesis of 5'-Bromo-3"'-ethylphenyl-5"'-chloro-2,2':5,2":5",2"'-quaterthiophene and 5",5""-Dichloro-3",3""-di(ethylphenyl)-2,2':5',2":5,2"':5"',2""-quinquethiophene:

[Chemical Formula 31]

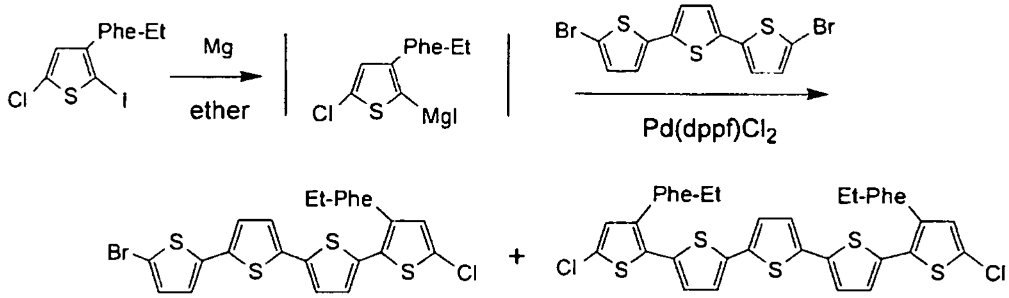


A Grignard's reagent prepared from 5.23 g (15 mM) of 5-chloro-3-ethylphenyl-2-iodothiophene and 0.40 g (16.5 mM) of magnesium in dry ether was added to a solution of 2.03 g (5.0 mM) of 5',5"-dibromo-2,2':5,2"-terthiophene prepared in Synthesis 9 dissolved in dry toluene (20 ml), and refluxed for 10 hours in the presence of 0.08 g (0.1 mM) of palladium diphenylphosphinoferrocene dichloride as a catalyst. After addition of 5% hydrochloric acid (20 ml) with thorough stirring, the aqueous layer was separated from the organic layer. The organic layer was washed with 5% aqueous sodium hydrogencarbonate (10 ml), and dried over sodium sulfate. The resultant crude product was purified by silica gel column chromatography (solvent:n-hexane) to recover a target product, 5'-bromo-3"'-ethylphenyl-5"'-chloro-2,2':5,2":5",2"'-quaterthiophene (0.86 g, yield 32%), and 5",5""-dichloro-3",3""-di(ethylphenyl)-2,2':5',2":5,2"':5"',2""-quinquethiophene (1.09 g, yield 31%).

5'-bromo-3"'-ethylphenyl-5"'-chloro-2,2':5,2":5",2"'-quaterthiophene was yellow needle crystal, and had a mp. of 114 to 117°C. The structure of the target product was identified by $^1$H NMR. The results are shown below.

$^1$H NMR (500MHz, $CDCl_3$) : δ 7.26 (d, J = 7.6Hz, 2H), 7.20 (d, J = 7.6Hz, 2H), 6.94-6.98 (m, 4H), 6.90 (s, 1H), 6.89 (d, J = 3.6Hz, 1H), 6.83 (d, J = 3.6Hz, 1H), 2.68 (q, J = 7.6Hz, 2H), 1.27(t, J = 7.6Hz, 3H)

5",5""-dichloro-3",3""-di(ethylphenyl)-2,2':5',2":5,2"':5"',2""-quinquethiophene was yellow needle crystal and had a mp. of 173 to 176°C. The structure of the target product was identified by $^1$H NMR. The results are shown below.

$^1$H NMR (500MHz, $CDCl_3$): δ 7.26 (d, J = 7.6Hz, 4H), 7.19 (d, J = 7.6Hz, 4H), 6.94 (d, J = 3.6Hz, 2H), 6.92 (s, 2H), 6.90 (s, 2H), 6.82 (d, J = 3.6Hz, 2H), 2.68 (q, J = 7.6Hz, 4H), 1.26 (t, J = 7.6Hz, 6H)

[Synthesis 11]

·Synthesis of 5"-Hexyl-5""-chloro-3""-ethylphenyl-2,2':5',2":5,2"':5"',2""-quinquethiophene:

[Chemical Formula 32]

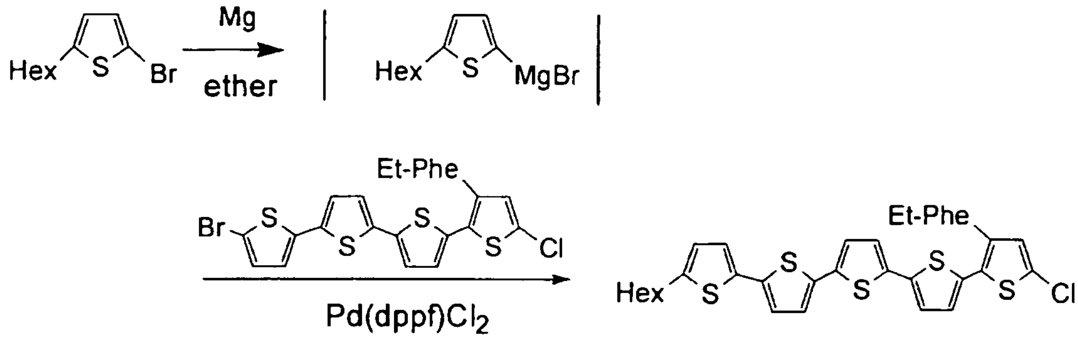


A Grignard's reagent prepared from 0.99 g (4.0 mM) of 5-bromo-2-hexylthiophene and 0.11 g (4.4 mM) of magnesium in dry ether was added to a solution of 1.20 g (2.2 mM) of 5'-bromo-3'''-ethylphenyl-5'''-chloro-2,2':5,2":5", 2'''-quaterthiophene prepared in Synthesis 10 dissolved in dry toluene (10 ml), and stirred at room temperature for 3 hours in the presence of 0.018 g (0.022 mM) of palladium diphenylphosphinoferrocene dichloride as a catalyst. After addition of 5% hydrochloric acid (20 ml) with thorough stirring, the aqueous layer was separated from the organic layer. The organic layer was washed with 5% aqueous sodium hydrogencarbonate (10 ml), and dried over sodium sulfate. The resultant crude product was purified by silica gel column chromatography (n-hexane:chloroform = 19:1) to recover a target product, 5"-hexyl-5''''-chloro-3''''-ethylphenyl-2,2':5',2":5,2''':5''',2''''-quinquethiophene (1.1 g). The target product was obtained in a yield of 78% as yellow powder with a mp. of 114 to 116°C. The structure of the target product was identified by $^1$H NMR. The results are shown below.

$^1$H NMR (500MHz, $CDCl_3$): δ 7.27 (d, J = 7.6Hz, 2H), 7.20 (d, J = 7.6Hz, 2H), 7.03-6.95 (m, 6H), 6.90 (s, 1H), 6.83 (d, J = 3.6Hz, 1H), 6.66 (d, J = 3.6Hz, 1H), 2.79 (t, J = 7.6Hz, 2H), 2.69 (q, J = 7.6Hz, 2H), 1.68 (m, 2H), 1.42-1.28 (m, 6H), 1.27 (t, J = 7.6Hz, 3H), 0.89 (t, J = 7.6Hz, 3H)

[Synthesis 12]

·Synthesis of Oligothiophene C (Decamer)

[Chemical Formula 33]

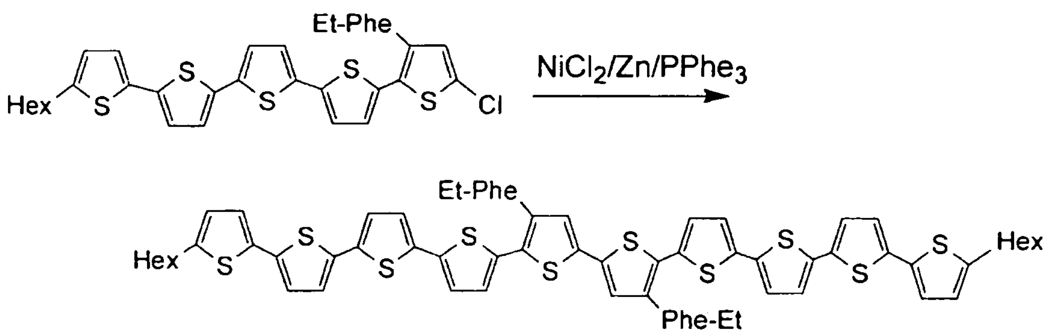


Under nitrogen stream, 0.25 g (1.9 mM) of anhydrous nickel chloride, 2.00 g (7.6 mM) of triphenylphosphine and 0.12 g (1.9 mM) of zinc powder were added to 25 ml of dry DMF, and stirred at 50°C for one hour. Then, 1.24 g (1.9 mM) of 5"-hexyl-5''''-chloro-3''''-ethylphenyl-2,2':5',2":5,2''':5''',2''''-quinquethiophene prepared in Synthesis 11 was added, and stirred at 50°C for one hour. The reaction mixture was poured into 100 ml of water. The resultant reddish black precipitate was suction-filtered out, and washed with 100 ml of water. This precipitate was Soxhlet-extracted with n-hexane to remove triphenylphosphine, and then Soxhlet-extracted with chloroform to recover a target product, the oligothiophene C (decamer) (1.0 g). The target product was obtained in a yield of 77% as red powder with a mp. of 216 to 219°C. The structure of the target product was identified by $^1$H NMR. The results are shown below.

$^1$H NMR (500MHz, $CDCl_3$): $\delta$7.36 (d, J = 7.6Hz, 4H), 7.23 (d, J = 7.6Hz, 4H), 7.16 (s, 2H), 7.04-6.96 (m, 12H), 6.89 (d, J = 3.6Hz, 2H), 6.68 (d, J = 3.6Hz, 2H), 2.80 (t, J = 7.6Hz, 4H), 2.72 (q, J = 7.6Hz, 4H), 1.68 (m, 4H), 1.42-1.24 (m, 12H), 1.28 (t, J = 7.6Hz, 6H), 0.90 (t, J = 7.6Hz, 6H)

[Synthesis 13]

·Synthesis of Oligothiophene D (Heptamer)

[Chemical Formula 34]

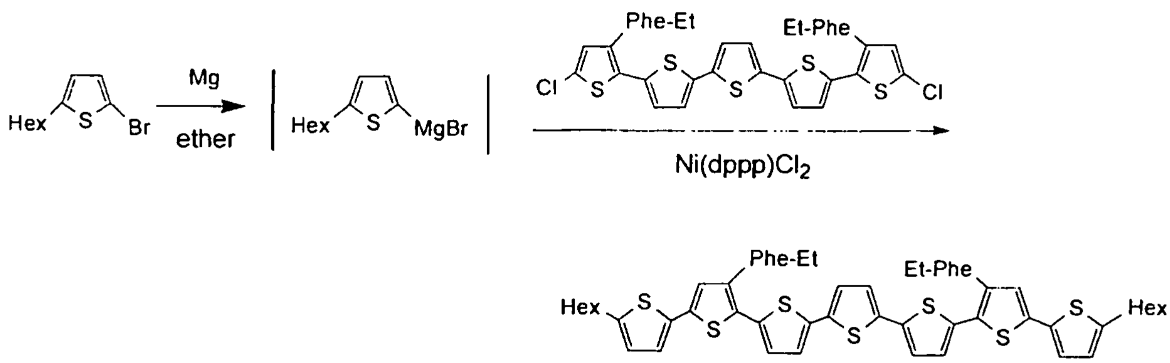


A Grignard's reagent prepared from 1.48 g (6.0 mM) of 5-bromo-2-hexylthiophene and 0.16 g (6.6 mM) of magnesium in dry ether was added to a solution of 1.03 g (1.5 mM) of 5",5""-dichloro-3",3""-di(ethylphenyl)-2,2':5',2":5,2"':5"',2""-quinquethiophene prepared in Synthesis 10 dissolved in dry toluene (10 ml), and refluxed for 3 hours in the presence of 0.02 g (0.03 mM) of nickel diphenylphosphinopropane dichloride as a catalyst. After addition of 5% cold hydrochloric acid (20 ml) with thorough stirring, the aqueous layer was separated from the organic layer. The organic layer was washed with 5% aqueous sodium hydrogencarbonate (10 ml), and dried over sodium sulfate. The resultant crude product was purified by silica gel column chromatography (n-hexane:chloroform = 19:1) to recover a target product, the oligothiophene D (heptamer) (1.06 g). The target product was obtained in a yield of 74% as red powder with a mp. of 116 to 118˚C. The structure of the target product was identified by $^1$H NMR. The results are shown below.

$^1$H NMR (500MHz, $CDCl_3$): $\delta$7.33 (d, J = 7.6Hz, 4H), 7.22 (d, J = 7.6Hz, 4H), 7.04 (s, 2H), 7.01 (d, J = 3.6Hz, 2H), 6.95 (d, J = 3.6Hz, 2H), 6.92 (s, 2H), 6.85 (d, J = 3.6Hz, 2H), 6.69 (d, J = 3.6Hz, 2H), 2.80 (t, J = 7.6Hz, 4H), 2.70 (q, J = 7.6Hz, 4H), 1.68 (m, 4H), 1.42-1.30 (m, 18H), 0.90 (t, J = 7.6Hz, 6H)

[Synthesis 14]

·Synthesis of Oligothiophene E (Hexamer)

[Chemical Formula 35]

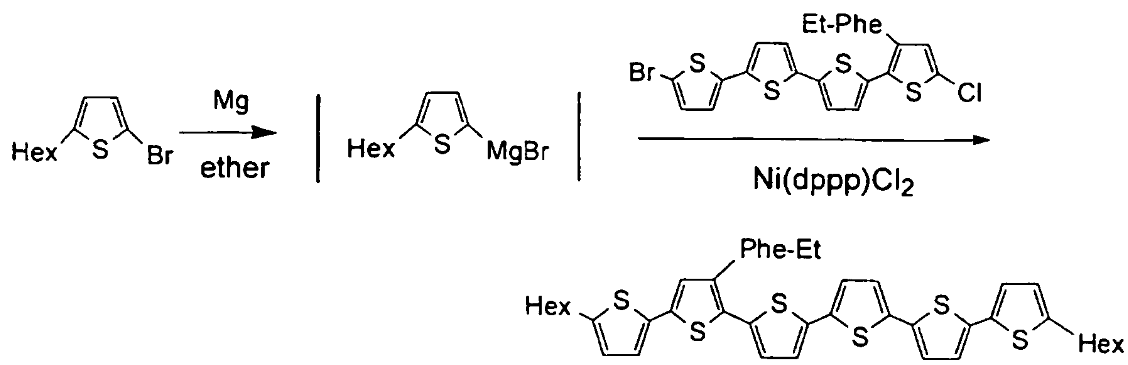


A Grignard's reagent prepared from 1.48 g (6.0 mM) of 5-bromo-2-hexylthiophene and 0.16 g (6.6 mM) of magnesium in dry ether was added to 2.19 g (4.0 mM) of 5'-bromo-3'''-ethylphenyl-5'''-chloro-2,2':5,2":5",2'''-quaterthiophene dissolved in dry toluene (10 ml), and stirred at room temperature for 3 hours in the presence of 0.022 g (0.04 mM) of nickel diphenylphosphinopropane dichloride as a catalyst. After addition of 5% hydrochloric acid (20 ml) with thorough stirring, the aqueous layer was separated from the organic layer. The organic layer was washed with 5% aqueous sodium hydrogencarbonate (10 ml), and dried over sodium sulfate. The resultant crude product was purified by silica gel column chromatography (solvent:n-hexane) to recover a target product, the oligothiophene E (hexamer) (1.10 g). The target product was obtained in a yield of 48% as orange powder with a mp. of 114 to 116°C. The structure of the target product was identified by $^1$H NMR. The results are shown below.

$^1$H NMR (500MHz, $CDCl_3$): δ7.32 (d, J = 7.6Hz, 2H), 7.21 (d, J = 7.6Hz, 2H), 7.03 (s, 1H), 7.00-6.92 (m, 7H), 6.84 (d, J = 3.6Hz, 1H), 6.68 (d, J = 3.6Hz, 1H), 6.66 (d, J = 3.6Hz, 1H), 2.78 (m, 4H), 2.69 (q, J = 7.6Hz, 2H), 1.69 (m, 4H), 1.41-1.26 (m, 12H), 1.27 (t, J = 7.6Hz, 3H), 0.90 (t, J = 7.6Hz, 6H)

[Synthesis 15]

[Chemical Formula 36]

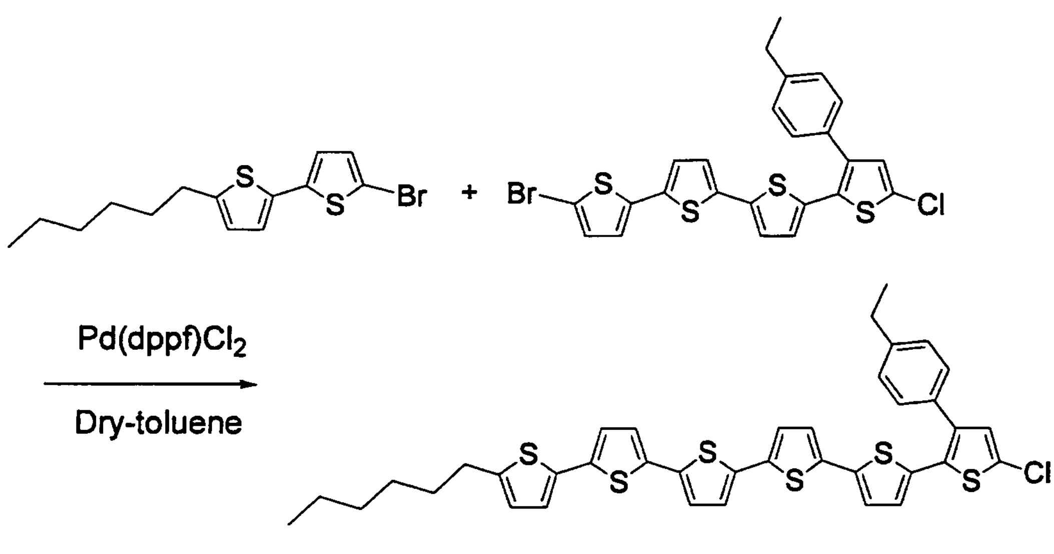


A Grignard's reagent prepared from 1.32 g (4.0 mM) of 5-hexyl-5'-bromo-2,2'-bithiophene available from Sigma-Aldrich, Inc. and 0.11 g (4.4 mM) of magnesium in dry ether was added to a solution of 1.20 g (2.2 mM) of 5'-bromo-3'''-ethylphenyl-5'''-chloro-2,2':5,2":5",2'''-quaterthiophene prepared in Synthesis 10 dissolved in dry toluene (10 ml), and stirred at room temperature for 3 hours in the presence of 0.018 g (0.022 mM) of palladium diphenylphosphinoferrocene dichloride as a catalyst. After addition of 5% hydrochloric acid (20 ml) with thorough stirring, the aqueous layer was separated from the organic layer. The organic layer was washed with 5% aqueous sodium hydrogencarbonate (10 ml),

and dried over sodium sulfate. The resultant crude product was purified by silica gel column chromatography (n-hexane: chloroform = 19:1) to recover a target product, 5"-hexyl-5""'-chloro-3""'-ethylphenyl-2,2':5',2":5,2"':5"',2"":5"",2""'-sexithiophene (1.2 g). The target product was obtained in a yield of 78% as yellow powder with a mp. of 123 to 126°C. The structure of the target product was identified by MALDI-TOF-MS.

[Synthesis 16]

·Synthesis of Oligothiophene F (Dodecamer)

[Chemical Formula 37]

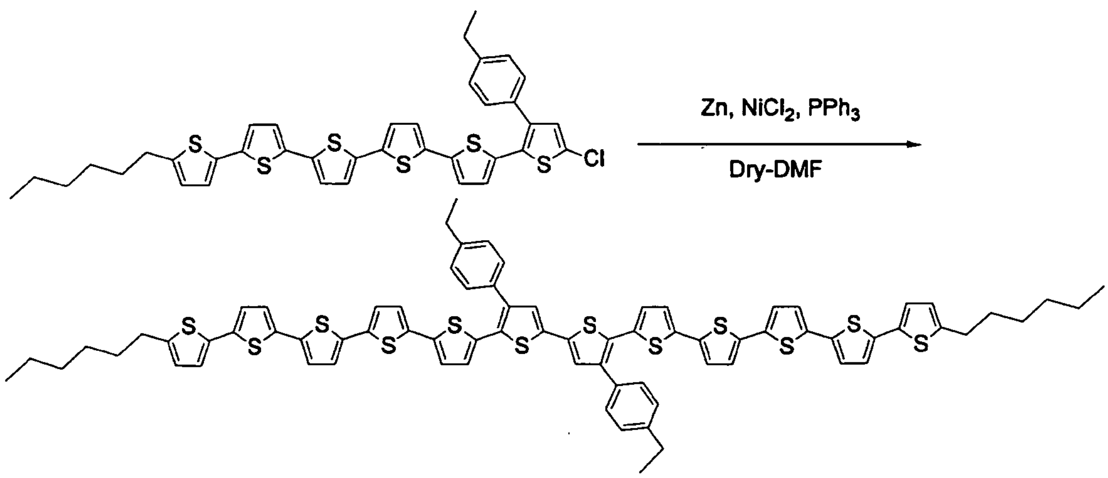


Under nitrogen stream, 0.25 g (1.9 mM) of anhydrous nickel chloride, 2.00 g (7.6 mM) of triphenylphosphine and 0.12 g (1.9 mM) of zinc powder were added to 25 ml of dry DMF, and stirred at 50°C for one hour. Then, 1.26 g (1.9 mM) of 5"-hexyl-5""'-chloro-3""'-ethylphenyl-2,2':5',2":5,2"':5"',2"":5"",2""'-sexithiophene prepared in Synthesis 15 was added, and stirred at 50°C for one hour. The reaction mixture was poured into 100 ml of water. The reddish black precipitate was suction-filtered out, and washed with 100 ml of water. This precipitate was Soxhlet-extracted with n-hexane to remove triphenylphosphine, and then Soxhlet-extracted with chloroform to recover a target product, the oligothiophene F (dodecamer) (1.0 g). The target product was obtained in a yield of 77% as red powder with a mp. of 236 to 240°C.

[Synthesis 17]

[Chemical Formula 38]

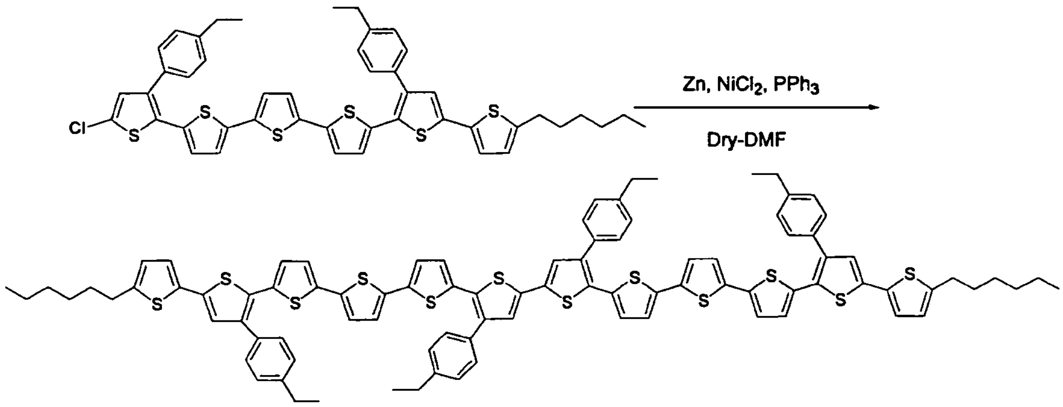


A Grignard's reagent prepared from 0.25 g (1.0 mM) (1.0 mM) of 5-bromo-2-hexylthiophene and 0.03 g (1.2 mM) of magnesium in dry ether was added to a solution of 1.03 g (1.5 mM) of 5",5""-dichloro-3",3""-di(ethylphenyl)-2,2':5',2":5,2"':5"',2""-quinquethiophene prepared in Synthesis 10 dissolved in dry toluene (10 ml), and refluxed for 3 hours in the presence of 0.02 g (0.03 mM) of nickel diphenylphosphinopropane dichloride as a catalyst. After addition of 5% cold hydrochloric acid (20 ml) with thorough stirring, the aqueous layer was separated from the organic layer. The organic layer was washed with 5% aqueous sodium hydrogencarbonate (10 ml), and dried over sodium sulfate. The resultant crude product was purified by silica gel column chromatography (n-hexane:chloroform = 19:1) to recover a target product, 5""'-hexyl-5"-chloro-3",3""-di(ethylphenyl)-2,2':5',2":5,2"':5"',2"":5"",2""'-sexithiophene (0.88 g). The target product was obtained in a yield of 68% as orange powder with a mp. of 126 to 128°C. The structure of the target product was identified by $^1H$ NMR. The results are shown below.

$^1H$ NMR (500MHz, $CDCl_3$): δ 7.26 (d, J = 7.6Hz, 4H), 7.19 (d, J = 7.6Hz, 4H), 6.94 (d, J = 3.6Hz, 2H), 6.92 (s, 2H), 6.90 (s, 2H), 6.82 (d, J = 3.6Hz, 2H), 2.68 (q, J = 7.6Hz, 4H), 1.26 (t, J = 7.6Hz, 6H), 1.40-1.25 (m, 10H), 0.89 (t, J = 7.6Hz, 3H).

[Synthesis 18]

·Synthesis of Oligothiophene G (Dodecamer)

Under nitrogen stream, 0.25 g (1.9 mM) of anhydrous nickel chloride, 2.00 g (7.6 mM) of triphenylphosphine and 0.12 g (1.9 mM) of zinc powder were added to 25 ml of dry DMF, and stirred at 50°C for one hour. Then, 1.38 g (1.9 mM) of 5""'-hexyl-5"-chloro-3",3""-di(ethylphenyl)-2,2':5',2":5,2"':5"',2"":5"",2""'-sexithiophene prepared in Synthesis 17 was added, and stirred at 50°C for one hour. The reaction mixture was poured into 100 ml of water. The reddish black precipitate was suction-filtered out, and washed with 100 ml of water. This precipitate was Soxhlet-extracted with n-hexane to remove triphenylphosphine, and then Soxhlet-extracted with chloroform to recover a target product, the oligothiophene G (dodecamer) (0.9 g). The target product was obtained in a yield of 76% as red powder with a mp. of 228 to 232°C. The structure of the target product was identified by MALDI-TOF-MS.

[Example 1]

[II. Evaluation of Organic Semiconductor Material]

[II-1. Evaluation of Ionization Potential]

The oligothiophene A (hexamer) (50 mg) prepared in Synthesis 4 was dissolved in chloroform (1 mL) to prepare a solution. This solution was spin-coated on a 2.5 by 2.5 $cm^2$ quartz substrate available from Furuuchi Chemical Corporation at 1000 rpm. A satisfactory film was produced. The ionization potential (Ip) of this film was determined with a photoelectron spectrometer Model PCR-101 available from Sumitomo Heavy Industries Advanced Machinery. As a reference, an α-6T film deposited on a quartz substrate under vacuum was used (See Comparative Example 1 described below). Fig. 4 is a graph of the ionization potentials observed. The ionization potential (Ip) of the oligothiophene A (hexamer) was 5.34 eV, while that of α-6T was 4.7 eV. This result indicates that the oligothiophene A (hexamer), which is the organic semiconductor material of the present invention, is more resistive to oxidation compared to the α-6T,

which is a conventional organic semiconductor material. The observed ionization potential of the oligothiophene A is shown in Table 1.

[II-2. Evaluation of Crystallinity]

X-ray diffractometry was conducted for the oligothiophene film formed of the oligothiophene A (hexamer) prepared in [Evaluation of Ionization Potential] using a RINT-2000/PC available from Rigaku Corporation. Fig. 5 shows the X-ray diffraction pattern. In-Plane X-ray diffractometry confirmed that this oligothiophene film was a crystalline semiconductor layer. Table 1 shows the result. In Table 1, the mark o indicates a crystalline semiconductor layers, and the mark X indicates the other layer.

[II-3. Evaluation of Solubility]

The oligothiophene A (hexamer) was dissolved in each of toluene, xylene, ethylbenzene, mesitylene, cyclopentanone, cyclohexanone, methyl chloride, carbon tetrachloride, chlorobenzene, dichlorobenzene, trichlorobenzene, nitrobenzene, methyl ethyl ketone, benzoic acid esters, anisole, phenetole, butyl phenyl ether, methoxytoluene, and benzyl ethyl ether at 30°C, and each solubility was determined. Table 1 shows the result. In Table 1, the mark o indicates the case where the solubilities of 0.1% by weight and 0.3% by weight for each solvent were observed, and the mark X indicates the other case.

[III. Organic FET]

A 300 nm thick oxide film was formed on an N-type silicon substrate (Sb-doped, resistivity 0.02 Ωcm or less, made by Sumitomo Metal Industries, Ltd.), followed by forming gold electrodes (a source electrode and a drain electrode) with a gap of 10 μm in length (L) and 500 μm in width (W) on the oxide film by photolithography. The oxide film outside the gold electrode area was etched in a hydrofluoric acid/ammonium fluoride etchant. Gold was deposited on the exposed Si area to form an electrode for applying a voltage to silicon substrate (a gate electrode).

In 1 mL of chloroform was dissolved 50 mg of the oligothiophene A (hexamer) prepared in Synthesis 4 to prepare a solution. All of the evaluations of the following deposition and electrical characteristics for the organic semiconductors were performed under nitrogen atmosphere in order to prevent the effects of oxygen and humidity. On the substrate on which the electrodes were formed, the prepared solution was spin-coated at 1000 rpm. A satisfactory film (a semiconductor layer) was formed. This provided an organic FET (the FET of the present invention) composed of the organic semiconductor material of the present invention, that is, the oligothiophene A (hexamer) as the semiconductor layer.

The electrical characteristics of the resultant organic FET were determined using a semiconductor parameter analyzer 4155C available from Agilent Technologies, Inc. The operation of the organic FET can be expressed by the following equations wherein $I_d$ is the electrical current as a function of the voltage $V_d$ applied between source and drain electrodes; Vg is the voltage applied to source and gate electrodes; $V_t$ is the threshold voltage; $C_i$ is the electrostatic capacity of the insulating film per unit area; L is the length of the gap between the source electrode and the drain electrode, and W is the width; and μ is the mobility of the semiconductor layer.

[Equation 1]

In the case of $V_d < V_g - V_t$

$$I_d = \mu C_i (W/L)\left[(V_g - V_t)V_d - \left(V_d^2/2\right)\right]$$

In the case of $V_d > V_g$

$$I_d = (1/2)\mu C_i (W/L)(V_g - V_t)^2$$

The μ can be determined by the current-voltage characteristics of the device. The mobility μ was determined from the slope of the saturation current component $I_d^{1/2}$-$V_g$ in the equation (B) although either the equation (A) or (B) may be used. The threshold voltage $V_t$ was determined from the intercept at $I_d$=0 in this plot, and the on-off ratio was

determined from the ratio of Vg = 30 V at an applied voltage $V_d$ of -30 V to $I_d$s at -50 V.

FIG. 6 is a graph of the electrical characteristics of the organic FET prepared by the above procedure. The organic FET exhibited were excellent electrical characteristics, for example, a mobility of $7.0\times10^{-3}$ $cm^2/Vs$, a $V_t$ of -0.7 V, and an on-off ratio of $2.7\times10^6$. Table 1 also shows the measured electrical characteristics of the oligothiophene A (the mobility $\mu$, the threshold voltage $V_t$, and the on-off ratio).

[IV. The ratio of the Molecular Weight of the Aromatic Moiety of $R^1$ and $R^2$ in the General Formula (1) to the Molecular Weight of the Moiety of the 6 to 20 Five-Membered and/or Six-Membered Aromatic Rings Bonded to Each Other]

The ratio of the molecular weight of the aromatic moiety of $R^1$ and $R^2$ in the general formula (1) to the molecular weight of the moiety of the 6 to 20 five-membered and/or six-membered aromatic rings bonded to each other was calculated for the oligothiophene A (hexamer). The result is shown in the column "Ratio of Aryl Substituent to Aromatic Moiety in the Backbone Chain" in Table 1.

[Example 2]

The evaluations of the ionization potential, the crystallinity, the solubility, and the electrical characteristics of the organic FET, and the calculation of the ratio of the molecular weight of the aromatic moiety of $R^1$ and $R^2$ in the general formula (1) to the molecular weight of the moiety of the 6 to 20 five-membered and/or six-membered aromatic rings bonded to each other were carried out as in Example 1, except that the oligothiophene A was replaced with the oligothiophene B prepared in Synthesis 8. Table 1 shows the results.

[Example 3]

The evaluations of the ionization potential, the crystallinity, the solubility, and the electrical characteristics of the organic FET, and the calculation of the ratio of the molecular weight of the aromatic moiety of $R^1$ and $R^2$ in the general formula (1) to the molecular weight of the moiety of the 6 to 20 five-membered and/or six-membered aromatic rings bonded to each other were carried out as in Example 1, except that the oligothiophene A was replaced with the oligothiophene C prepared in Synthesis 12. Table 1 shows the results.

[Example 4]

The evaluations of the ionization potential, the crystallinity, the solubility, and the electrical characteristics of the organic FET, and the calculation of the ratio of the molecular weight of the aromatic moiety of $R^1$ and $R^2$ in the general formula (1) to the molecular weight of the moiety of the 6 to 20 five-membered and/or six-membered aromatic rings bonded to each other were carried out as in Example 1, except that the oligothiophene A was replaced with the oligothiophene D prepared in Synthesis 13. Table 1 shows the results.

[Example 5]

The evaluations of the ionization potential, the crystallinity, the solubility, and the electrical characteristics of the organic FET, and the calculation of the ratio of the molecular weight of the aromatic moiety of $R^1$ and $R^2$ in the general formula (1) to the molecular weight of the moiety of the 6 to 20 five-membered and/or six-membered aromatic rings bonded to each other were carried out as in Example 1, except that the oligothiophene A was replaced with the oligothiophene E prepared in Synthesis 14. Table 1 shows the results.

[Example 6]

The evaluations of the ionization potential, the crystallinity, the solubility, and the electrical characteristics of the organic FET, and the calculation of the ratio of the molecular weight of the aromatic moiety of $R^1$ and $R^2$ in the general formula (1) to the molecular weight of the moiety of the 6 to 20 five-membered and/or six-membered aromatic rings bonded to each other were carried out as in Example 1, except that the oligothiophene A was replaced with the oligothiophene F prepared in Synthesis 16. Table 1 shows the results.

[Example 7]

The evaluations of the ionization potential, the crystallinity, the solubility, and the electrical characteristics of the organic FET, and the calculation of the ratio of the molecular weight of the aromatic moiety of $R^1$ and $R^2$ in the general formula (1) to the molecular weight of the moiety of the 6 to 20 five-membered and/or six-membered aromatic

rings bonded to each other were carried out as in Example 1, except that the oligothiophene A was replaced with the oligothiophene G prepared in Synthesis 18. Table 1 shows the results.

[Comparative Example 1]

The evaluations of the ionization potential, the crystallinity, the solubility, and the electrical characteristics of the organic FET, and the calculation of the ratio of the molecular weight of the aromatic moiety of $R^1$ and $R^2$ in the general formula (1) to the molecular weight of the moiety of the 6 to 20 five-membered and/or six-membered aromatic rings bonded to each other were carried out as in Example 1, except that the oligothiophene A was replaced with α-6T (α-sezithiophene). Table 1 shows the results.

[Table 1: Results of Examples]

| | Type of Organic semiconductor | | Ionization Potential (eV) | Mobility ($cm^2/Vs$) | Vt (V) | On-Off Ratio | Crystallinity of Film | Solubility in Specific Solvents | | Ratio of Aryl Substituent to Aromatic Moiety in the Backbone Chain |
|---|---|---|---|---|---|---|---|---|---|---|
| | | | | | | | | 0.1% by weight | 0.3% by weight | |
| Example 1 | Oligothiophene A | 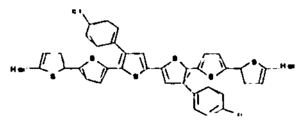 | 5.34 | $7.0\times10^{-3}$ | -0.7 | $2.7\times10^{6}$ | ○ | ○ | ○ | 24% |
| Example 2 | Oligothiophene B | 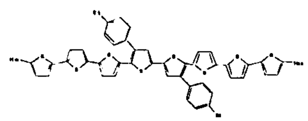 | 5.24 | $1.8\times10^{-2}$ | -3.4 | $1.3\times10^{4}$ | ○ | ○ | ○ | 19% |
| Example 3 | Oligothiophene C | 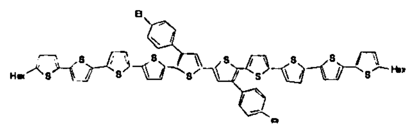 | 5.26 | $1.8\times10^{-2}$ | 0.44 | $1.2\times10^{3}$ | ○ | ○ | ○ | 16% |
| Example 4 | Oligothiophene D | 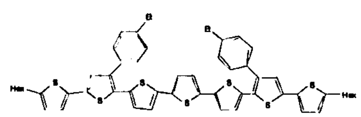 | 5.48 | $3.2\times10^{-3}$ | -2.4 | $3.9\times10^{3}$ | ○ | ○ | ○ | 21% |
| Example 5 | Oligothiophene E | 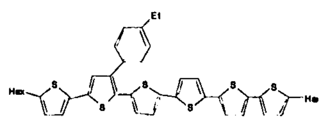 | 5.24 | $1.3\times10^{-2}$ | 39 | $2.4\times10^{1}$ | ○ | ○ | ○ | 12% |
| Example 6 | Oligothiophene F | 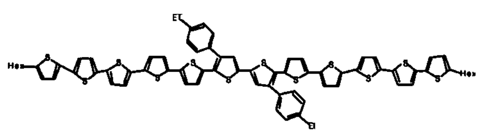 | 5.18 | $1.2\times10^{-1}$ | 1.2 | $4.6\times10^{6}$ | ○ | ○ | ○ | 14% |

(continued)

| | Type of Organic semiconductor | | Ionization Potential (eV) | Mobility ($cm^2/Vs$) | Vt (V) | On-Off Ratio | Crystallinity of Film | Solubility in Specific Solvents | | Ratio of Aryl Substituent to Aromatic Moiety in the Backbone Chain |
|---|---|---|---|---|---|---|---|---|---|---|
| | | | | | | | | 0.1% by weight | 0.3% by weight | |
| Example 7 | Oligothiophene G | 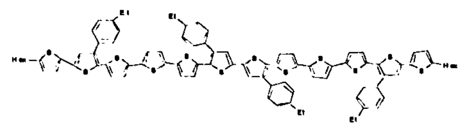 | 5.46 | $5.7\times10^{-2}$ | 9 | $6.1\times10^{3}$ | ○ | ○ | ○ | 24% |
| Comparative Example 1 | | α-6T | 4.7 | $4.5\times10^{-2}$ | 12 | $6.6\times10^{3}$ | ○ | ○ | ○ | 0% |

Conclusion

Table 1 shows that the organic semiconductor materials according to Examples 1 to 7 of the present invention can be subject to coating processes, and have high regularity, high crystallinity, and high stability and that the organic field-effect transistors composed of these materials in the semiconductor have excellent electrical characteristics such as mobility, and high oxidation resistance, and high stability of electrical characteristics.

Industrial Applicability

The organic semiconductor material of the present invention has excellent electrical characteristics and organic semiconductor characteristics. Therefore, the organic semiconductor material of the present invention can be preferably used in various applications such as organic FETs, and then is very useful.

Although the present invention has been described in detail with reference to particular embodiments, it is apparent to those skilled in the art that various modifications can be made thereto without departing from the spirit and scope of the present invention. The present application is based on Japanese Patent Application (Patent Application No. 2005-273725) filed on September 21, 2005, and Japanese Patent Application (Patent Application No. 2006-253927) filed on September 20, 2006, which are herein incorporated in their entireties by reference.

## Claims

**1.** An organic semiconductor material:

having 6 to 20 five-membered and/or six-membered aromatic rings bonded to each other, and having a partial structure represented by the formula (1):

[Chemical Formula 1]

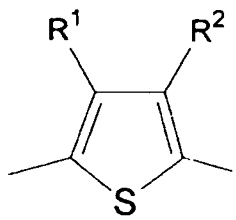

(1)

wherein, $R^1$ and $R^2$ independently represent a hydrogen atom or a monovalent organic group, provided that at least one of $R^1$ and $R^2$ is an optionally substituted aromatic group;
having a mobility of $1.0 \times 10^{-3}$ $cm^2/Vs$ or more, and
having an ionization potential in the solid state in the range of 4.8 eV to 5.6 eV.

**2.** The organic semiconductor material according to claim 1, wherein the organic semiconductor material has a solubility of 0.1% by weight or more at 30°C in at least any one solvent of toluene, xylene, ethylbenzene, mesitylene, cyclopentanone, cyclohexanone, methyl chloride, carbon tetrachloride, chlorobenzene, dichlorobenzene, trichlorobenzene, nitrobenzene, methyl ethyl ketone, benzoic acid esters, anisole, phenetole, butyl phenyl ether, methoxytoluene, and benzyl ethyl ether.

**3.** The organic semiconductor material according to claim 1 or claim 2, wherein the ratio of the molecular weight of the aromatic moiety of $R^1$ and $R^2$ in the general formula (1) to the molecular weight of the moiety of the 6 to 20 five-membered and/or six-membered aromatic rings bonded to each other is 5% or more.

**4.** The organic semiconductor material according to any one of claims 1 to 3, having a partial structure represented by the formula (2):

[Chemical Formula 2]

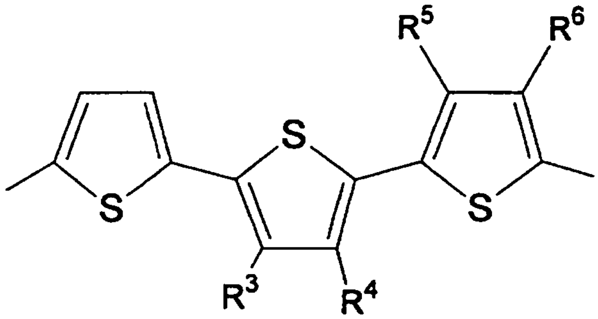

(2)

wherein, $R^3$ to $R^6$ independently represent a hydrogen atom or a monovalent organic group, provided that at least one of $R^3$ to $R^6$ is an optionally substituted aromatic group.

**5.** The organic semiconductor material according to any one of claims 1 to 4, being an oligothiophene.

**6.** An organic field-effect transistor, comprising:

at least a substrate; an insulator on the substrate; a gate electrode and a semiconductor separated by the insulator; and a source electrode and a drain electrode in contact with the semiconductor,
the semiconductor comprising at least the organic semiconductor material according to any one of claims 1 to 5.

**7.** The organic field-effect transistor according to claim 6, wherein the semiconductor is made by a solution coating process.

FIG. 1

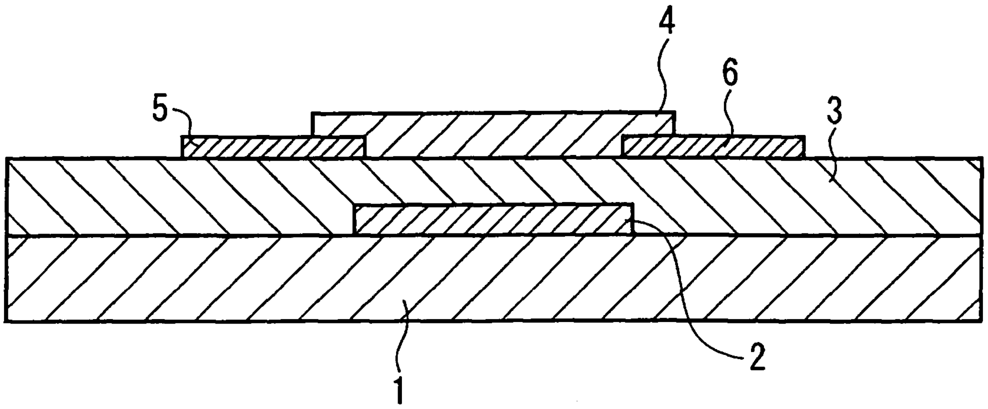


FIG. 2

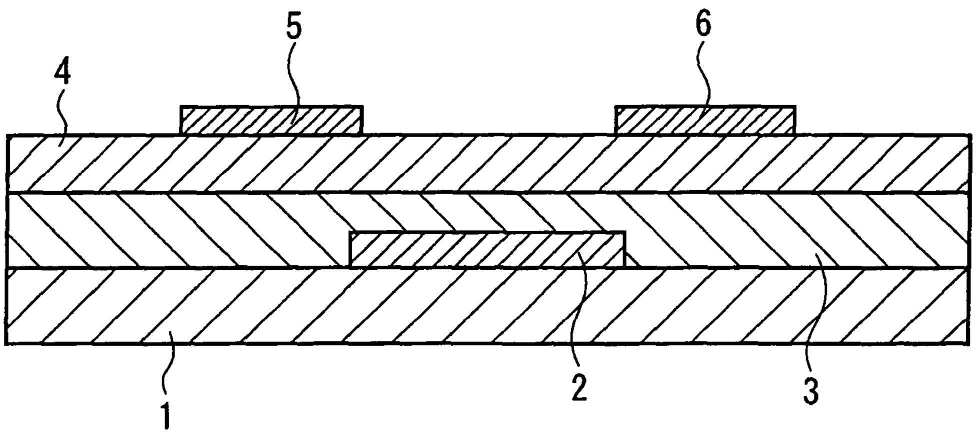


FIG. 3

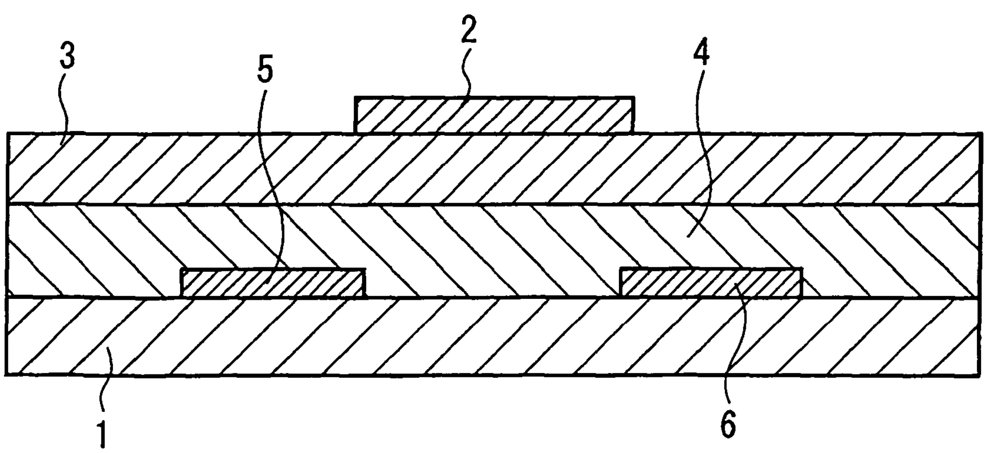

FIG. 4

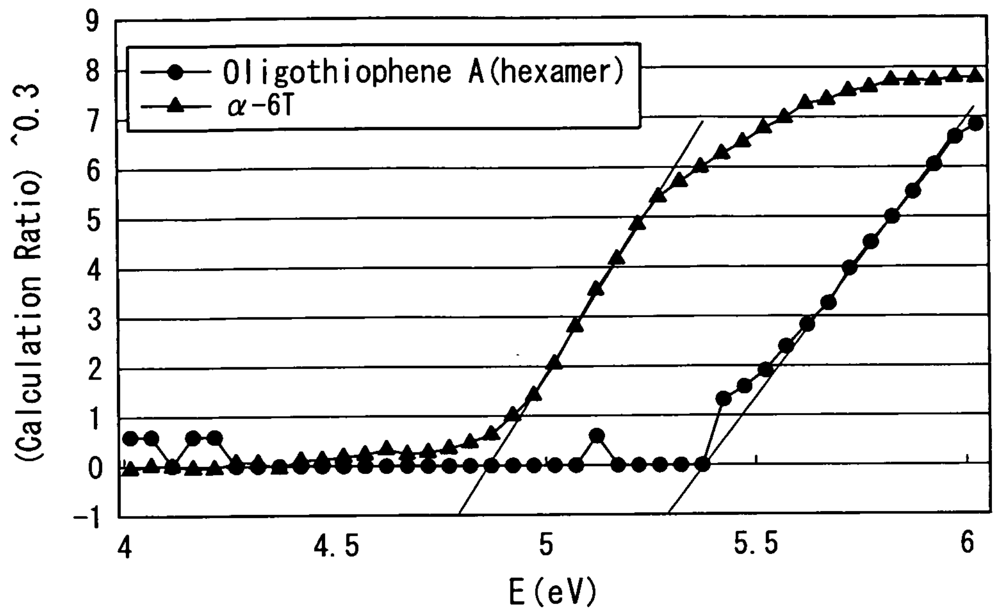
9
8
7
6
5
4
3
2
1
0
-1
(Calculation Ratio) ^0.3
Oligothiophene A(hexamer)
α-6T
4
4.5
5
5.5
6
E(eV)

FIG. 5

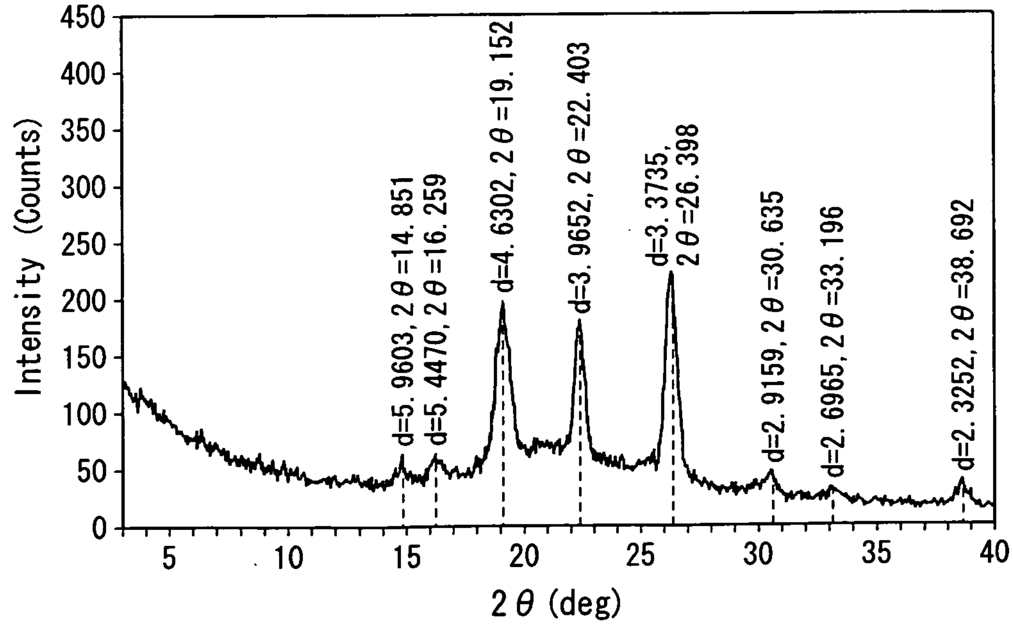
450
400
350
300
250
200
150
100
50
0
Intensity (Counts)
d=5.9603, 2θ=14.851
d=5.4470, 2θ=16.259
d=4.6302, 2θ=19.152
d=3.9652, 2θ=22.403
d=3.3735, 2θ=26.398
d=2.9159, 2θ=30.635
d=2.6965, 2θ=33.196
d=2.3252, 2θ=38.692
5
10
15
20
25
30
35
40
2θ (deg)

FIG. 6

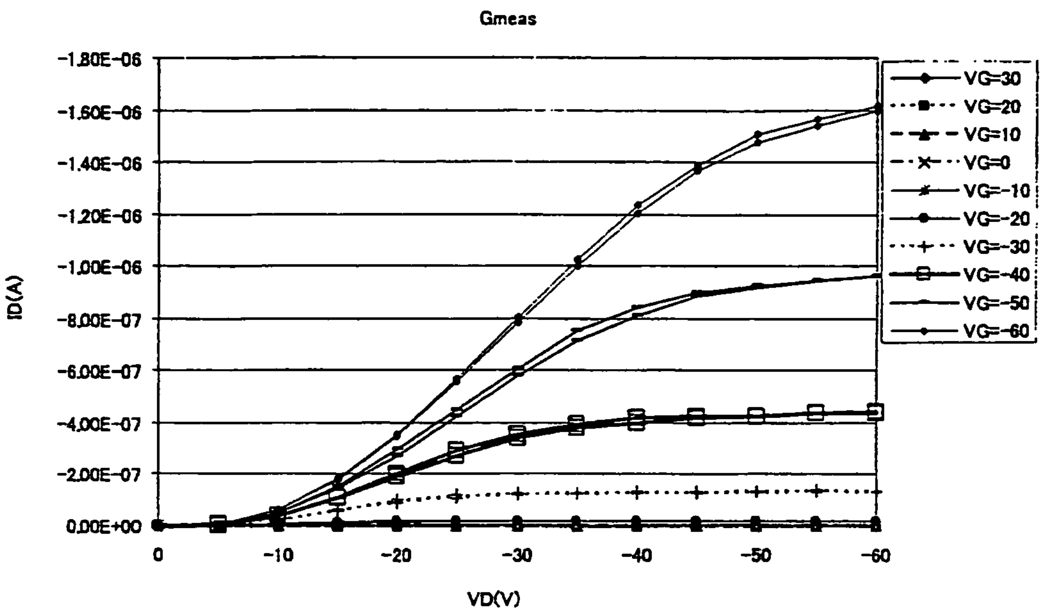
Gmeas
ID(A)
-1.80E-06
-1.60E-06
-1.40E-06
-1.20E-06
-1.00E-06
-8.00E-07
-6.00E-07
-4.00E-07
-2.00E-07
0.00E+00
0
-10
-20
-30
-40
-50
-60
VD(V)
VG=30
VG=20
VG=10
VG=0
VG=-10
VG=-20
VG=-30
VG=-40
VG=-50
VG=-60

**INTERNATIONAL SEARCH REPORT**

International application No.
PCT/JP2006/318649

A. CLASSIFICATION OF SUBJECT MATTER
*H01L51/30*(2006.01)i, *H01L29/786*(2006.01)i, *H01L51/05*(2006.01)i

According to International Patent Classification (IPC) or to both national classification and IPC

B. FIELDS SEARCHED

Minimum documentation searched (classification system followed by classification symbols)
H01L51/30, H01L29/786, H01L51/05, C07D333/10

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2003-192772 A (Merk Patent GmbH), 09 July, 2003 (09.07.03), Full text & EP 1279690 A1 & US 2003/047720 A1 & KR 2003/010508 A | 1-7 |
| A | JP 8-18125 A (Hitachi, Ltd.), 19 January, 1996 (19.01.96), Full text & US 5705826 A & KR 332365 B | 1-7 |
| A | JP 2003-176338 A (Merk Patent GmbH), 24 June, 2003 (24.06.03), Full text & EP 1279689 A2 & US 2003/062509 A1 | 1-7 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 04 December, 2006 (04.12.06) | 12 December, 2006 (12.12.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.
PCT/JP2006/318649

C (Continuation). DOCUMENTS CONSIDERED TO BE RELEVANT

| Category* | Citation of document, with indication, where appropriate, of the relevant passages | Relevant to claim No. |
|---|---|---|
| P,A | WO 2005/122277 A (Konica Minolta Holdings Kabushiki Kaisha), 22 December, 2005 (22.12.05), Par. Nos. [0017] to [0037] & US 2005/274954 A1 | 1-7 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*


### Patent documents cited in the description

- US 5347144 A
- JP 4133351 A
- JP 2003268083 A
- JP 2005273725 A
- JP 2006253927 A

### Non-patent literature cited in the description

- *Journal of Materials Chemistry,* 2000, 571-588
- **SONE et al.** *Bulletin of the Chemical Society of Japan,* 1970, 1411
- **GARNIER et al.** *Journal of the American Chemical Society,* 1993, vol. 115, 8716
- *Macromolecules,* 2001, vol. 34 (21), 7570-7572